(19) Europäisches Patentamt
European Patent Office
Office européen des brevets

(11) EP 3 202 821 A1

(12) **EUROPEAN PATENT APPLICATION**
published in accordance with Art. 153(4) EPC

(43) Date of publication:
**09.08.2017 Bulletin 2017/32**

(21) Application number: **15847058.3**

(22) Date of filing: **29.09.2015**

(51) Int Cl.:
***C08G 77/24*** *(2006.01)* ***H01L 33/56*** *(2010.01)*

(86) International application number:
**PCT/JP2015/077492**

(87) International publication number:
**WO 2016/052495 (07.04.2016 Gazette 2016/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **03.10.2014 JP 2014205230**

(71) Applicant: **Sumitomo Chemical Company, Ltd.**
**Chuo-ku**
**Tokyo 104-8260 (JP)**

(72) Inventors:
- **MASUI Kentaro**
  **Tsukuba-shi**
  **Ibaraki 300-3294 (JP)**
- **NAKAZONO Akiko**
  **Tsukuba-shi**
  **Ibaraki 300-3294 (JP)**

(74) Representative: **Winter, Brandl, Fürniss, Hübner, Röss, Kaiser, Polte - Partnerschaft mbB**
**Patent- und Rechtsanwaltskanzlei**
**Alois-Steinecker-Strasse 22**
**85354 Freising (DE)**

(54) **SILICONE RESIN, SEALING MATERIAL COMPOSITION FOR UV-LED, CURED PRODUCT AND SEALING MATERIAL FOR UV-LED**

(57) A silicone resin which is a condensation product of a silane compound, the condensation product of the silane compound containing a constitutional unit derived from a fluorine atom-containing silane compound in which a fluoroalkyl group having at least one fluorine atom is bonded to a silicon atom.

EP 3 202 821 A1

## Description

### TECHNICAL FIELD

The present invention relates to a silicone resin, as well as an encapsulating material composition for UV-LEDs, a cured product and an encapsulating material for UV-LEDs that use the silicone resin.

Priority is claimed on Japanese Patent Application No. 2014-205230, filed October 3, 2014, the content of which is incorporated herein by reference.

### BACKGROUND ART

Silicone resins exhibit excellent stability and have favorable electrical insulation properties, and are therefore widely used as protective materials for electrical and electronic equipment, optical equipment, and members used in such equipment. Various investigations are being undertaken to improve the properties of silicone resins by adjusting the constitutional components of the silicone resins.

For example, Patent Document 1 discloses a cured product of a curable composition for an optical material, prepared by adding a siloxane oligomer and/or silane having a fluoroalkyl group to a liquid addition curing type silicone rubber composition. It is disclosed that because this composition has favorable antifoaming properties during production and exhibits excellent transparency and the like, the cured product of the composition has favorable optical properties while suffering no deterioration in the refractive index and the like.

### PRIOR ART LITERATURE

#### Patent Documents

Patent Document 1: JP-2005-36155-A

### DISCLOSURE OF INVENTION

#### Problems to be Solved by the Invention

On the other hand, it is known that conventional silicone resins, when used in the open air, degrade due to oxidation reactions that are thought to be caused by oxygen. However, a satisfactorily effective countermeasure to this problem has yet to be found.

The present invention has been developed in light of these circumstances, and has an object of providing a silicone resin for which degradation caused by oxidation reactions is satisfactorily suppressed.

#### Means for Solving the Problems

In order to achieve the above object, the present invention provides a silicone resin which is a condensation product of a silane compound, wherein the condensed silane compound includes a fluorine atom-containing silane compound in which a fluoroalkyl group having at least one fluorine atom is bonded to a silicon atom.

In the silicone resin of the present invention, it is preferable that the fluorine atom-containing silane compound is a compound represented by general formula (1) shown below, and that of the total condensed silane compound, the proportion of the fluorine atom-containing silane compound is at least 52% by mass.

$$R^1_nSiX^1_{4-n} \quad .... \qquad (1)$$

(In the formula, n represents 1 or 2, $R^1$ represents a partially fluorinated alkyl group having 1 to 20 carbon atoms, and $X^1$ represents an alkoxy group, a chlorine atom, a bromine atom or an iodine atom.)

In the silicone resin of the present invention, it is preferable that the fluorine atom-containing silane compound is a compound represented by general formula (2) shown below, and that the functional number of the silicone resin is not more than 3.0.

$$R^2_mSiX^2_{4-m} \quad .... \qquad (2)$$

(In the formula, m represents 1 or 2, $R^2$ represents a perfluoroalkyl group having 1 to 20 carbon atoms, and $X^2$ represents an alkoxy group, a chlorine atom, a bromine atom or an iodine atom.)

In the silicone resin of the present invention, the number of carbon atoms in the fluoroalkyl group of the fluorine atom-containing silane compound is preferably from 1 to 3.
Further, the present invention also provides an encapsulating material composition for a UV-LED, the encapsulating material composition containing the above silicone resin.
Further, the present invention also provides a cured product obtained by heating the above silicone resin.
Furthermore, the present invention also provides an encapsulating material for a UV-LED, the encapsulating material obtained by heating the above silicone resin.
In other words, the present invention includes the following aspects.

[1] A silicone resin which is a condensation product of a silane compound, the condensation product of the silane compound containing a constitutional unit derived from a fluorine atom-containing silane compound in which a fluoroalkyl group having at least one fluorine atom is bonded to a silicon atom.
[2] The silicone resin according to [1], wherein the constitutional unit derived from the fluorine atom-containing silane compound is a constitutional unit derived from a compound represented by general formula (1) shown below, and the proportion of constitutional units derived from the fluorine atom-containing silane compound relative to the total mass of the condensation product of the silane compound is at least 52% by mass.

$$R^1_nSiX^1_{4-n} \ldots. \qquad (1)$$

(In the formula, n represents 1 or 2, $R^1$ represents a partially fluorinated alkyl group having 1 to 20 carbon atoms, and $X^1$ represents an alkoxy group, a chlorine atom, a bromine atom or an iodine atom.)
[3] The silicone resin according to [1], wherein the constitutional unit derived from the fluorine atom-containing silane compound is a constitutional unit derived from a compound represented by general formula (2) shown below, and the average functional number of the silicone resin is not more than 3.0.

$$R^2_mSiX^2_{4-m} \ldots. \qquad (2)$$

(In the formula, m represents 1 or 2, $R^2$ represents a perfluoroalkyl group having 1 to 20 carbon atoms, and $X^2$ represents an alkoxy group, a chlorine atom, a bromine atom or an iodine atom.)
[4] The silicone resin according to any one of [1] to [3], wherein the number of carbon atoms in the fluoroalkyl group of the constitutional unit derived from the fluorine atom-containing silane compound is from 1 to 3.
[5] An encapsulating material composition for a UV-LED, the encapsulating material composition containing the silicone resin according to any one of [1] to [4], and one or more other components.
[6] A cured product of the silicone resin according to any one of [1] to [4].
[7] An encapsulating material for a UV-LED, the encapsulating material containing a cured product of the silicone resin according to any one of [1] to [4].

Effects of the Invention

The present invention is able to provide a silicone resin for which degradation caused by oxidation reactions is satisfactorily suppressed.

BRIEF DESCRIPTION OF THE DRAWINGS

FIG. 1 is a graph illustrating the results of quantum chemical calculations of the heat of reaction in each stage of the oxidation reaction of a group represented by the formula $-O-Si(-CH_3)(-O-)-O-$.
FIG. 2 is a graph illustrating the results of quantum chemical calculations of the heats of reaction for abstraction reactions of a hydrogen atom or a fluorine atom bonded to the C atom of various groups having an Si-C bond.
FIG. 3 is a cross-sectional view schematically illustrating one example of a semiconductor light-emitting device using a silicone resin that represents one embodiment of the present invention.

BEST MODE FOR CARRYING OUT THE INVENTION

<Silicone resin>

The silicone resin that represents one embodiment of the present invention is a condensation product of a

silane compound, wherein the condensation product of the silane compound contains a constitutional unit derived from a fluorine atom-containing silane compound in which a fluoroalkyl group having at least one fluorine atom is bonded to a silicon atom.

In the silicone resin, the main chain is composed of a condensation product of the silane compound, and has a structure in which the fluoroalkyl group is bonded to some or all of the silicon atoms that constitute this main chain. By ensuring that the silicone resin has this type of structure, the silicone resin and the cured product thereof are able to exhibit satisfactory suppression of degradation caused by oxidation reactions.

The condensation product of the silane compound may be any condensation product containing at least the aforementioned constitutional unit derived from a fluorine atom-containing silane compound, and may be either a condensation product composed solely of constitutional units derived from the fluorine atom-containing silane compound, or a condensation product containing constitutional units derived from the fluorine atom-containing silane compound and constitutional units derived from other silane compounds.

In the present description, unless specifically stated otherwise, the simple term "silane compound" means a silane compound that participates in a condensation to form the silicone resin described above.

In the present description, a "constitutional unit derived from a silane compound" means a constitutional unit (also referred to as a repeating unit) in the condensation product of the silane compound that has been modified to enable condensation of the silane compound.

The fluorine atom-containing silane compound and other silane compounds used in forming the condensation product of the silane compound may each be composed of a single compound or two or more compounds, and in the case of two or more compounds, the combination of compounds and the ratio therebetween may be set as appropriate.

In the fluorine atom-containing silane compound, the number of fluorine atoms in the fluoroalkyl group is not particularly limited within the range determined by the number of carbon atoms in the fluoroalkyl group, and may be one or more, or two or more. In other words, the fluoroalkyl group may be a partially fluorinated alkyl group or a perfluoroalkyl group. When the fluoroalkyl group is a partially fluorinated alkyl group, there are no particular limitations on the bonding position of each fluorine atom. In the present description, a "partially fluorinated alkyl group" means a fluorinated alkyl group in which at least one hydrogen atom of the alkyl group has been substituted with a fluorine atom, but excluding perfluoroalkyl groups in which all of the hydrogen atoms have been substituted with fluorine atoms, namely a fluoroalkyl group having at least one hydrogen atom.

The alkyl group in the fluoroalkyl group is preferably an alkyl group having a carbon number of 1 to 3, and examples include a methyl group, ethyl group and propyl group.

The silicone resin is an organic polymer having siloxane linkages as the main chain, and the functional number of the silicone resin can be represented by the average functional number of a compound (polyorganosiloxane) represented by general compositional formula (F3) shown below.

$$(R^{11}R^{12}R^{13}SiO_{1/2})_M(R^{14}R^{15}SiO_{2/2})_D(R^{16}SiO_{3/2})_T(SiO_{4/2})_Q \cdots \quad (F3)$$

In the formula, each of $R^{11}$ to $R^{16}$ independently represents a hydrocarbon group such as an alkyl group or phenyl group, or a halogen atom. When any of $R^{11}$ to $R^{16}$ represents a halogen atom, these atoms are considered oxygen atoms in the formula (F3) when counting the functional number.

Further, each of M, D, T and Q is a number of at least 0 but less than 1, provided that $M+D+T+Q = 1$.

Each alkyl group for $R^{11}$ to $R^{16}$ is, independently, preferably an alkyl group having a carbon number of 1 to 3, and specific examples include a methyl group, ethyl group, propyl group and butyl group.

Each halogen atom for $R^{11}$ to $R^{16}$ is, independently, preferably a fluorine atom.

The repeating units that constitute the polyorganosiloxane represented by the above formula (F3) include monofunctional units [$R^{11}R^{12}R^{13}SiO_{1/2}$] (triorganosilhemioxanes), bifunctional units [$R^{14}R^{15}SiO_{2/2}$] (diorganosiloxanes), trifunctional units [$R^{16}SiO_{3/2}$] (organosilsesquioxanes) and tetrafunctional units [$SiO_{4/2}$] (silicates), and the functional number for the polyorganosiloxane is determined on the basis of the compositional ratio between these four types of repeating units.

In other words, the average functional number for the polyorganosiloxane can be calculated by formula (F4) shown below.

$$\text{Average functional number} = (2\times D + 3\times T + 4\times Q) / (D+T+Q) \quad \ldots (F4)$$

For example, a typical bifunctional thermosetting silicone resin is a polyorganosiloxane in which all of the repeating units in the above formula (F3) are ($R^{14}R^{15}SiO_{2/2}$), namely a polyorganosiloxane composed solely of diorganosiloxane structures (-O-Si($R^{14}$)($R^{15}$)-O-), and the functional number in this case (namely, the average functional

number) is 2.0.

The weight-average molecular weight of the silicone resin is preferably from 100 to 500,000, and more preferably from 200 to 100,000.

Generally, a value obtained by measurement by a gel permeation chromatography (GPC) method can be used as the weight-average molecular weight. Specifically, a sample of the polymer that is to be measured is dissolved in a suitable solvent, the solution is then passed through a column using a filler having a multitude of pores together with a mobile phase solution, thereby fractionating the polymer inside the column based on the size of the molecular weight, and the fractionated products are detected using a detector such as a differential refractometer, UV meter, viscometer or light scattering detector. The weight-average molecular weight is generally expressed as a polystyrene-equivalent value referenced against standard polystyrenes. In this description, weight-average molecular weights are expressed as these polystyrene-equivalent values. The column used may be selected appropriately in accordance with the anticipated weight-average molecular weight.

[Silicone resin (1)]

Preferred examples of the silicone resin include silicone resins in which the aforementioned constitutional unit derived from the fluorine atom-containing silane compound is a constitutional unit derived from a compound represented by general formula (1) shown below (hereinafter also abbreviated as the "fluorine atom-containing silane compound (1)"), wherein the proportion of constitutional units derived from the fluorine atom-containing silane compound (1) relative to the total mass of the condensation product containing the constitutional units derived from the silane compound is at least 52% by mass but not more than 100% by mass (in this description, this type of silicone resin is sometimes referred to as the "silicone resin (1)").

$$R^1{}_nSiX^1{}_{4-n} \quad .... \qquad (1)$$

(In the formula, n represents 1 or 2, $R^1$ represents a partially fluorinated alkyl group having 1 to 20 carbon atoms, and $X^1$ represents an alkoxy group, a chlorine atom, a bromine atom or an iodine atom.)

In the fluorine atom-containing silane compound (1), $R^1$ represents a partially fluorinated alkyl group having 1 to 20 carbon atoms.

The partially fluorinated alkyl group for $R^1$ in which some of the hydrogen atoms have each been substituted with a fluorine atom may be a linear, branched or cyclic group, and in the case of a cyclic group, may be a monocyclic or polycyclic group.

The linear or branched alkyl group in which some of the hydrogen atoms have each been substituted with a fluorine atom has 1 to 20 carbon atoms, and examples of the alkyl group itself include a methyl group, ethyl group, n-propyl group, isopropyl group, n-butyl group, isobutyl group, sec-butyl group, tert-butyl group, n-pentyl group, isopentyl group, neopentyl group, tert-pentyl group, 1-methylbutyl group, n-hexyl group, 2-methylpentyl group, 3-methylpentyl group, 2,2-dimethylbutyl group, 2,3-dimethylbutyl group, n-heptyl group, 2-methylhexyl group, 3-methylhexyl group, 2,2-dimethylpentyl group, 2,3-dimethylpentyl group, 2,4-dimethylpentyl group, 3,3-dimethylpentyl group, 3-ethylpentyl group, 2,2,3-trimethylbutyl group, n-octyl group, isooctyl group, 2-ethylhexyl group, nonyl group, decyl group, undecyl group, dodecyl group, tridecyl group, tetradecyl group, pentadecyl group, hexadecyl group, heptadecyl group, octadecyl group, nonadecyl group and eicosyl group.

Among the above groups, a methyl group, ethyl group, propyl group or butyl group is preferable.

The cyclic alkyl group in which some of the hydrogen atoms have each been substituted with a fluorine atom has 3 to 20 carbon atoms, and examples of the alkyl group itself include a cyclopropyl group, cyclobutyl group, cyclopentyl group, cyclohexyl group, cycloheptyl group, cyclooctyl group, cyclononyl group, cyclodecyl group, norbornyl group, isobornyl group, 1-adamantyl group, 2-adamantyl group and tricyclodecyl group, as well as groups in which at least one hydrogen atom within one of the above cyclic alkyl groups has been substituted with a linear, branched or cyclic alkyl group.

Here, examples of the linear, branched or cyclic alkyl group that may substitute a hydrogen atom of the aforementioned cyclic alkyl group include linear or branched alkyl groups having 1 to 17 carbon atoms and cyclic alkyl groups having 3 to 17 carbon atoms from among the groups listed above for the alkyl group in which some of the hydrogen atoms have each been substituted with a fluorine atom.

The linear or branched alkyl group itself having 1 to 17 carbon atoms is preferably a methyl group, an ethyl group or a propyl group.

When the partially fluorinated alkyl group for $R^1$ has at least two carbon atoms, there are no particular limitations on the position of the carbon atom to which each fluorine atom is bonded, but in terms of achieving a more powerful suppression effect on degradation of the silicone resin due to oxidation reactions, the carbon atom is preferably either the carbon atom where the partially fluorinated alkyl group is bonded to the silicon atom or a carbon atom close to this carbon atom, and is most preferably the carbon atom where the partially fluorinated alkyl group is bonded to the silicon

atom.

On the other hand, when the partially fluorinated alkyl group for $R^1$ has at least two carbon atoms, in terms of the ease of production of the fluorine atom-containing silane compound (1) or the ease of procurement of a commercially available product, the carbon atom to which each fluorine atom is bonded is preferably as distant as possible from the carbon atom where the partially fluorinated alkyl group is bonded to the silicon atom, and is most preferably the carbon atom at the terminal at the opposite end to the carbon atom where the partially fluorinated alkyl group is bonded to the silicon atom.

The partially fluorinated alkyl group for $R^1$ preferably has 1 to 15 carbon atoms, more preferably 1 to 10 carbon atoms, even more preferably 1 to 6 carbon atoms, and most preferably 1 to 3 carbon atoms. Specifically, a trifluoropropyl group is preferred.

In the fluorine atom-containing silane compound (1), $X^1$ represents an alkoxy group, a chlorine atom, a bromine atom or an iodine atom.

In the alkoxy group for $X^1$, the alkyl group bonded to the oxygen atom may be a linear, branched or cyclic group, and in the case of a cyclic group, may be a monocyclic or polycyclic group.

Examples of the alkoxy group for $X^1$ include monovalent groups in which a linear, branched or cyclic alkyl group, such as those listed above for the alkyl group itself in the group for $R^1$ in which some of the hydrogen atoms have each been substituted with a fluorine atom, is bonded to an oxygen atom.

Linear, branched and cyclic alkoxy groups corresponding with these types of alkyl groups are described below in further detail.

The linear or branched alkoxy group preferably has 1 to 20 carbon atoms, and specific examples of such alkoxy groups include a methoxy group, ethoxy group, n-propoxy group, isopropoxy group, n-butoxy group, isobutoxy group, sec-butoxy group, tert-butoxy group, n-pentyloxy group, isopentyloxy group, neopentyloxy group, tert-pentyloxy group, 1-methylbutyloxy group, n-hexyloxy group, 2-methylpentyloxy group, 3-methylpentyloxy group, 2,2-dimethylbutyloxy group, 2,3-dimethylbutyloxy group, n-heptyloxy group, 2-methylhexyloxy group, 3-methylhexyloxy group, 2,2-dimethylpentyloxy group, 2,3-dimethylpentyloxy group, 2,4-dimethylpentyloxy group, 3,3-dimethylpentyloxy group, 3-ethylpentyloxy group, 2,2,3-trimethylbutyloxy group, n-octyloxy group, isooctyloxy group, 2-ethylhexyloxy group, nonyloxy group, decyloxy group, undecyloxy group, dodecyloxy group, tridecyloxy group, tetradecyloxy group, pentadecyloxy group, hexadecyloxy group, heptadecyloxy group, octadecyloxy group, nonadecyloxy group and eicosyloxy group. Among the above groups, a methyl group or an ethyl group is preferable.

The cyclic alkoxy group preferably has 3 to 20 carbon atoms, and specific examples of such alkoxy groups include a cyclopropyloxy group, cyclobutyloxy group, cyclopentyloxy group, cyclohexyloxy group, cycloheptyloxy group, cyclooctyloxy group, cyclononyloxy group, cyclodecyloxy group, norbornyloxy group, isobornyloxy group, 1-adamantyloxy group, 2-adamantyloxy group and tricyclodecyloxy group, as well as groups in which at least one hydrogen atom within one of the above cyclic alkoxy groups has been substituted with a linear, branched or cyclic alkyl group. Among the above groups, a cyclohexyl group or a cyclopentyl group is preferable.

Examples of the alkyl group that may substitute a hydrogen atom of the cyclic alkoxy group include linear or branched alkyl groups having 1 to 17 carbon atoms and cyclic alkyl groups having 3 to 17 carbon atoms from among the groups listed above for the alkyl group itself in the group for $R^1$ in which some of the hydrogen atoms have each been substituted with a fluorine atom.

The alkoxy group for $X^1$ preferably has 1 to 15 carbon atoms, more preferably 1 to 10 carbon atoms, even more preferably 1 to 5 carbon atoms, and most preferably 1 to 3 carbon atoms. Specifically, a methyl group or an ethyl group is preferred.

In the fluorine atom-containing silane compound (1), n means the number of $R^1$ groups bonded to a single silicon atom (Si), and is 1 or 2. The number of $X^1$ moieties bonded to a single silicon atom (Si) is represented by "4-n", which has a value of 2 or 3.

Examples of commercially available products that can be procured as the fluorine atom-containing silane compound (1) include trichloro(1H,1H,2H,2H-tridecafluoro-n-octyl)silane, trichloro(1H,1H,2H,2H-heptadecafluorodecyl)silane, trimethoxy(3,3,3-trifluoropropyl)silane, triethoxy-1H,1H,2H,2H-heptadecafluorodecylsilane, trimethoxy(1H,1H,2H,2H-heptadecafluorodecyl)silane, trimethoxy(1H,1H,2H,2H-nonafluorohexyl)silane and trichloro(1H,1H,2H,2H-tridecafluoro-n-octyl)silane. Among these, it is preferable that trimethoxy(3,3,3-trifluoropropyl)silane is included in a larger amount than the other fluorine-containing silanes. When the amount of trimethoxy(3,3,3-trifluoropropyl)silane is large, the heating time required to obtain the cured product described below tends to shorten.

Further, the fluorine atom-containing silane compound (1) can also be obtained using conventional methods. For example, in the case of a compound having a structure in which the fluoroalkyl group is bonded to a silicon atom via an ethylene group ($-CH_2CH_2-$), the compound can be obtained by subjecting a fluoroalkene having a vinyl group ($-CH=CH_2$) at a molecular terminal to a hydrosilylation reaction with a compound having an Si-H bond in the presence of a platinum catalyst.

The silicone resin (1) is a resin in which the proportion of constitutional units derived from the fluorine atom-containing silane compound (1) relative to the total mass of the condensation product of the silane compound is at least 52% by mass. A resin in which this proportion is at least 55% by mass is preferable, and a resin in which the proportion is 60% by mass or greater is more preferable. Ensuring that the proportion of constitutional units derived from the fluorine atom-containing silane compound (1) is at least as large as the above lower limit enhances the suppression effect on degradation caused by oxidation reactions of the silicone resin (1) and the cured product thereof. On the other hand, there is no particular limitation on the upper limit for the proportion of constitutional units derived from the fluorine atom-containing silane compound (1), and the proportion may be 100% by mass relative to the total mass of the condensation product of the silane compound, meaning all of the constitutional units derived from the condensed silane compound are constitutional units derived from the fluorine atom-containing silane compound (1).

In other words, the silicone resin (1) is a resin in which the proportion of constitutional units derived from the fluorine atom-containing silane compound (1) relative to the total mass of the condensation product of the silane compound is at least 52% by mass but not more than 100% by mass, is preferably a resin in which this proportion is at least 55% by mass but not more than 100% by mass, and is more preferably a resin in which this proportion is at least 60% by mass but not more than 100% by mass.

In one aspect of the present invention, the constitutional unit derived from the fluorine atom-containing silane compound (1) is represented by general formula (1') shown below.

$$R^1{}_nSi(-O-)_{4-n} \cdots\cdot \qquad (1')$$

(In the formula, n and $R^1$ have the same meanings as above.)

[Silicone resin (2)]

Other examples of preferred silicone resins include silicone resins in which the aforementioned constitutional unit derived from the fluorine atom-containing silane compound is a constitutional unit derived from a compound represented by general formula (2) shown below (hereinafter also abbreviated as the "fluorine atom-containing silane compound (2)"), wherein the average functional number of the silicone resin is not more than 3.0 (in this description, this type of silicone resin is sometimes referred to as the "silicone resin (2)").

$$R^2{}_mSiX^2{}_{4-m} \cdots\cdot \qquad (2)$$

(In the formula, m represents 1 or 2, $R^2$ represents a perfluoroalkyl group having 1 to 20 carbon atoms, and $X^2$ represents an alkoxy group, a chlorine atom, a bromine atom or an iodine atom.)

In the fluorine atom-containing silane compound (2), $R^2$ represents a perfluoroalkyl group having 1 to 20 carbon atoms, which may be a linear, branched or cyclic group, and in the case of a cyclic group, may be a monocyclic or polycyclic group.

The perfluoroalkyl group for $R^2$ is represented by the general formula $C_1F_{21+1}$ (wherein 1 represents an integer of 1 to 20), and examples include groups in which all of the hydrogen atoms in the partially fluorinated alkyl groups described above for $R^1$ have been substituted with fluorine atoms.

The perfluoroalkyl group for $R^2$ preferably has 1 to 15 carbon atoms, more preferably 1 to 10 carbon atoms, even more preferably 1 to 5 carbon atoms, and most preferably 1 to 3 carbon atoms. Specifically, a trifluoromethyl group, pentafluoroethyl group or trifluoropropyl group is preferred.

In the fluorine atom-containing silane compound (2), $X^2$ represents an alkoxy group, a chlorine atom, a bromine atom or an iodine atom, and specific examples include the same groups and atoms as those listed above for $X^1$ in the fluorine atom-containing silane compound (1).

In the fluorine atom-containing silane compound (2), m means the number of $R^2$ groups bonded to a single silicon atom (Si), and is 1 or 2. The number of $X^2$ moieties bonded to a single silicon atom (Si) is represented by "4-m", which has a value of 2 or 3.

Specific examples of the fluorine atom-containing silane compound (2) include fluorine atom-containing silane compounds (2) in which m represents 1, such as trifluoromethyltrichlorosilane, trifluoromethyltrimethoxysilane, trifluoromethyltriethoxysilane, perfluoroethyltrichlorosilane, perfluoroethyltrimethoxysilane, perfluoroethyltriethoxysilane, perfluoropropyltrichlorosilane, perfluoropropyltrimethoxysilane, perfluoropropyltriethoxysilane, perfluoropentyltrichlorosilane, perfluoropentyltrimethoxysilane, perfluoropentyltriethoxysilane, perfluorooctyltrichlorosilane, perfluorooctyltrimethoxysilane and perfluorooctyltriethoxysilane; and
fluorine atom-containing silane compounds (2) in which m represents 2, such as di(trifluoromethyl)dichlorosilane, di(tritluoromethyl)dimethoxysilane, di(trifluoromethyl)diethoxysilane, di(perfluoroethyl)dichlorosilane, di(perfluoroethyl)dimethoxysilane, di(perfluoroethyl)diethoxysilane, di(perfluoropropyl)dichlorosilane, di(perfluoropropyl)dimethoxysilane, di(perfluoropropyl)diethoxysilane, di(perfluoropentyl)dichlorosilane, di(perfluoropentyl)dimethoxysilane, di(perfluoropentyl)diethoxysilane, di(perfluorooctyl)dichlorosilane, di(perfluorooctyl)dimethoxysilane and di(perfluorooctyl)diethoxysilane, but the fluorine atom-containing silane compound (2) is not limited to the above compounds.

Among the above compounds, trifluoromethyltrimethoxysilane, trifluoromethyltriethoxysilane, perfluoroethyltrimethoxysilane, perfluoroethyltriethoxysilane, perfluoropropyltrimethoxysilane and perfluoropropyltriethoxysilane are preferred.

The silicone resin (2) has an average functional number of at least 2.0 but not more than 3.0, and the value calculated using the above formula (F4) is at least 2.0 but not more than 3.0.

The fluorine atom-containing silane compound (2) can be produced in accordance with conventional methods.

For example, "Journal of Organometallic Chemistry, 316 (1986) 41" discloses a method for producing a fluorine atom-containing silane compound (2) using a phosphorus compound, as shown by the equation below.

[Chemical formula 1]

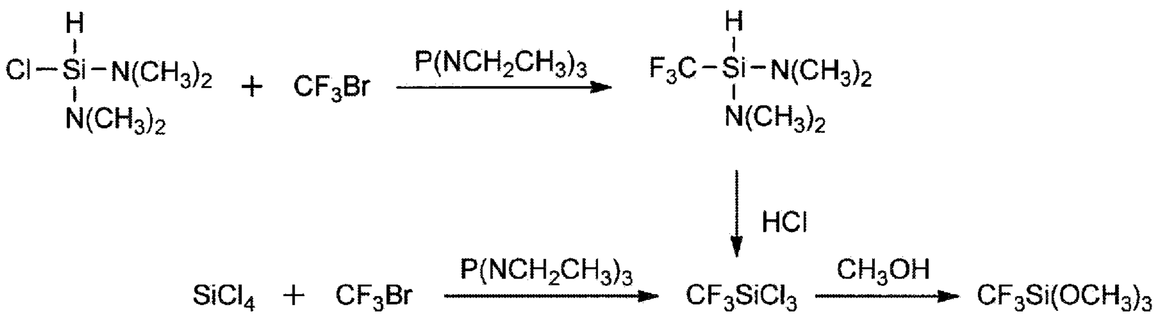


In another example, JP-H09-53022-A discloses a method for producing a fluorine atom-containing silane compound (2) using a Grignard reagent, as shown by the equation below.

[Chemical formula 2]

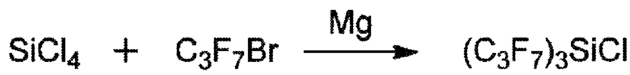


Further, "Angew. Chem. Int. Ed., 53, 5206" discloses a method for producing a fluorine atom-containing silane compound (2) using a lithium compound, as shown by the equation below.

[Chemical formula 3]

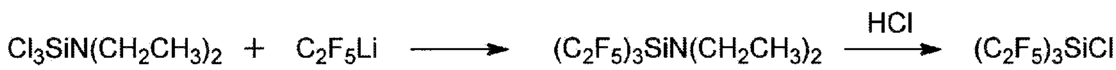


However, the production methods shown here are merely examples, and the method used for producing the fluorine atom-containing silane compound (2) is not limited to the above methods. Further, fluorine atom-containing silane compounds (2) not mentioned above may also be produced by reference to the above methods.

For the silicone resin (2), resins in which the proportion of constitutional units derived from the fluorine atom-containing silane compound (2) relative to the total mass of the condensation product of the silane compound is at least 10% by mass are preferred, resins in which this proportion is at least 20% by mass are more preferred, and resins in which the proportion is at least 30% by mass are even more preferred. Ensuring that the proportion of constitutional units derived from the fluorine atom-containing silane compound (2) is at least as large as the above lower limit enhances the suppression effect on degradation caused by oxidation reactions of the silicone resin (2) and the cured product thereof. On the other hand, there is no particular limitation on the upper limit for the proportion of constitutional units derived from the fluorine atom-containing silane compound (2), and the proportion may be 100% by mass relative to the total mass of the condensation product of the silane compound, meaning the entire condensed silane compound is composed of constitutional units derived from the fluorine atom-containing silane compound (2).

In other words, the silicone resin (2) is a resin in which the proportion of constitutional units derived from the

fluorine atom-containing silane compound (2) relative to the total mass of the condensation product of the silane compound is at least 10% by mass but not more than 100% by mass, is preferably a resin in which this proportion is at least 20% by mass but not more than 100% by mass, and is more preferably a resin in which this proportion is at least 30% by mass but not more than 100% by mass.

In one aspect of the present invention, the constitutional unit derived from the fluorine atom-containing silane compound (2) is represented by general formula (2') shown below.

$$R^2{}_mSi(-O-)_{4-m} \quad .... \qquad (2')$$

(In the formula, m and $R^2$ have the same meanings as above.)

In conventional silicone resins, it is surmised that the oxidation reactions that cause degradation proceed via radical generation and reaction in the following manner.

In other words, as shown below by equation (i), $SiCH_2\cdot$ is generated from $SiCH_3$ within the silicone resin. Moreover, as shown in equation (ii), SiO· is generated from this $SiCH_2\cdot$ via $SiCH_2O_2\cdot$, and as shown in equation (iii), Si· is generated from $SiCH_2\cdot$ via $SiCH_2O\cdot$. It is thought that, as shown in equation (iv), the SiO· and the Si· then react, thereby changing the structure of the main chain and causing degradation of the silicone resin. In the following equations (i) to (iv), some of the bonds of the silicon atoms are omitted.

$$SiCH_3 + O_2 \rightarrow SiCH_2\cdot + HO_2\cdot \quad .... \qquad (i)$$

$$SiCH_2\cdot + O_2 \rightarrow SiCH_2O_2\cdot \rightarrow SiO\cdot + CH_2O \quad .... \qquad (ii)$$

$$2(SiCH_2\cdot) + O_2 \rightarrow 2(SiCH_2O\cdot) \rightarrow 2Si\cdot + 2CH_2O \quad .... \qquad (iii)$$

$$SiO\cdot + Si\cdot \rightarrow SiOSi \qquad (iv)$$

Accordingly, degradation of the silicone resin due to oxidation reactions can be evaluated, for example, by measuring the infrared absorption spectrum of the silicone resin before and after a light resistance test, and comparing the peak intensities at 1260 to 1270 $cm^{-1}$ attributable to Si-CH bonds, and the peak intensities at 950 to 1180 $cm^{-1}$ attributable to Si-O-Si linkages.

In other words, a greater reduction in the peak intensity of the former and a greater increase in the peak intensity of the latter upon light irradiation can be evaluated as indicating lower light resistance for the silicone resin, whereas a smaller variation in the peak intensities can be evaluated as indicating superior light resistance for the silicone resin.

In this manner, as shown in equation (i), it is thought that the oxidation reactions of the silicone resin are initiated by abstraction of a hydrogen atom from a carbon atom, and as shown in equations (ii) and (iii), subsequently proceed through cleavage of the bond between the carbon atom and a silicon atom.

On the other hand, it is thought that the degradation of the silicone resin due to oxidation reactions can be suppressed by suppressing any one of the reactions represented by the above equations (i) to (iii). Accordingly, assuming the above oxidation reactions of a group represented by the formula $-O-Si(-CH_3)(-O-)-O-$, the heat of reaction $\Delta E1$ of the reaction of equation (i), the heat of reaction $\Delta E2$ of the reaction of equation (ii), and the heat of reaction $\Delta E3$ of the reaction of equation (iii) were calculated by quantum chemical calculations under the conditions described below. The values of $\Delta E1$, $\Delta E2$ and $\Delta E3$ can be represented by the differences, in the respective reactions, between the sum of the heats of formation of the compounds after reaction and the sum of the heats of formation of the compounds before reaction. The results of these quantum chemical calculations are shown in FIG. 1.

As illustrated in FIG. 1, $\Delta E1$ was about 59 kcal/mol, $\Delta E2$ was about -68 kcal/mol, and $\Delta E3$ was about -16 kcal/mol, meaning $\Delta E1 > \Delta E3 > \Delta E2$.

(Conditions for quantum chemical calculations of heats of reaction $\Delta E1$, $\Delta E2$ and $\Delta E3$)

In the quantum chemical calculations, a program called Gaussian 09 Revisopn A02 was used to determine the heats of formation by structural optimization calculations. The quantum chemical calculation method employed density functional theory, and used the B3LYP functional. Further, 6-311G" was used as the basis function.

Based on the above results, it is thought that suppressing the reaction of equation (i) should be the most effective in suppressing degradation of the silicone resin caused by oxidation reactions.

An example of a method for suppressing the reaction of equation (i), namely suppressing hydrogen abstraction from the carbon atom, is a method in which the hydrogen atoms are substituted in advance with fluorine atoms.

In a similar manner to the calculation of the heat of reaction $\Delta E1$ for the group represented by the formula $-O-Si(-CH_3)(-O-)-O-$ (hereinafter also referred to separately as "$\Delta E1$ (TH)"), quantum chemical calculations were used to

calculate the heat of reaction ΔE1 (DH) for a group represented by the formula $-O-Si(-CH_3)_2-O-$, the heat of reaction ΔE1 (TF) for a group represented by the formula $-O-Si(-CF_3)(-O-)-O-$, and the heat of reaction ΔE1 (DF) for a group represented by the formula $-O-Si(-CF_3)_2-O-$. The results of these quantum chemical calculations are shown in FIG. 2.

FIG. 2 shows that ΔE1 (TF) > ΔE1 (TH), ΔE1 (DF) > ΔE1 (DH), indicating that the fluorine atoms of $-CF_3$ are more difficult to sever from the carbon atom than the hydrogen atoms of $-CH_3$.

The description until this point has described the example in which one hydrogen atom of $SiCH_3$ has been substituted with a fluorine atom, but similar heats of reaction relationships to those described above are obtained for groups other than $SiCH_3$ as the group having an alkyl group bonded to a silicon atom, such as $SiCH_2CH_3$ and $SiCH_2CH_2CH_3$. Further, in groups having an alkyl group bonded to a silicon atom, such as $SiCH_3$, $SiCH_2CH_3$ and $SiCH_2CH_2CH_3$, similar heats of reaction relationships to those described above are also obtained when not one hydrogen atom, but rather two or more hydrogen atoms, are substituted with fluorine atoms.

In other words, in a group having an alkyl group bonded to a silicon atom, when at least one of the hydrogen atoms is substituted with a fluorine atom, the heat of reaction ΔE1 increases as described above, and the heat of reaction usually increases as the number of hydrogen atoms substituted with fluorine atoms increases. Accordingly, in order to increase the heat of reaction, the number of fluorine atoms in the fluorinated alkyl group bonded to the silicon atom should be at least one, but this number is preferably as high as possible, and a perfluoroalkyl group in which all of the hydrogen atoms have been substituted fluorine atoms is the most desirable. From this perspective, in the case of a fluorinated methyl group for example, the most preferred group is a trifluoromethyl group ($-CF_3$), the next most preferred group is a difluoromethyl group ($-CF_2H$), and the next most preferred group is a fluoromethyl group ($-CFH_2$). In those cases where a fluorinated alkyl group is bonded to a silicon atom, regardless of the number of hydrogen atoms that have been substituted with fluorine atoms, ΔE1 > ΔE2 and ΔE1 > ΔE3.

Further, in those cases where the fluorinated alkyl group bonded to the silicon atom is a partially fluorinated alkyl group, the carbon atom to which the fluorine atom(s) are bonded is preferably as close as possible to the silicon atom, and is more preferably the carbon atom bonded directly to (namely, adjacent to) the silicon atom. From this perspective, in the case of monofluoropropyl groups for example, the most preferred group is a 1-fluoropropyl group ($-CFHCH_2CH_3$), the next most preferred group is a 2-fluoropropyl group ($-CH_2CFHCH_3$), and the next most preferred group is a 3-fluoropropyl group ($-CH_2CH_2CFH_2$).

Furthermore, when the fluorinated alkyl group bonded to the silicon atom is a partially fluorinated alkyl group, then among groups having the same number of fluorine atoms in the partially fluorinated alkyl group, groups having more fluorine atoms bonded to carbon atoms closer to the silicon atom are preferred. From this perspective, in the case of trifluoroethyl groups for example, the most preferred group is a 1,1,2-trifluoroethyl group ($-CF_2CFH_2$), the next most preferred group is a 1,2,2-trifluoroethyl group ($-CFHCF_2H$), and the next most preferred group is a 2,2,2-trifluoroethyl group ($-CH_2CF_3$).

As indicated by the above results, the fluorine atom-containing silane compound (1) and the fluorine atom-containing silane compound (2) described above are both monomers that can be used favorably for the purpose of suppressing silicone resin degradation caused by oxidation reactions, and because the silicone resin (1), the silicone resin (2) and the cured products of these resins are condensation products of these types of monomers, they exhibit good suppression of degradation caused by oxidation reactions.

From the perspective of the types of heats of reaction described above, examples of preferred silicone resins include resins having bonds between silicon atoms and carbon atoms (Si-C bonds), and having, among these types of Si-C bonds, at least one Si-C bond (hereinafter also referred to as a "cleavage-resistant Si-C bond") for which the heat of reaction when the Si-C bond is cleaved radically by an oxidation reaction is greater than the heat of reaction when the bond (Si-C bond) between the silicon atom and the carbon atom in $SiCH_3$ is cleaved radically by an oxidation reaction. An example of this type of Si-C bond (namely, cleavage-resistant Si-C bond) in the aforementioned silicone resins is the bond between a fluoroalkyl group and a silicon atom, and examples of this fluoroalkyl group include the partially fluorinated alkyl groups in the aforementioned fluorine atom-containing silane compound (1) or the constitutional unit derived from the compound (1), and the perfluoroalkyl groups in the aforementioned fluorine atom-containing silane compound (2) or the constitutional unit derived from the compound (2).

In the above silicone resins, the proportion of the number of the aforementioned cleavage-resistant Si-C bonds relative to the total number of Si-C bonds is preferably at least 10% but not more than 100%, and is more preferably at least 20% but not more than 100%.

The silicone resins described above can be produced by performing a condensation (polycondensation) reaction using either a single silane compound, or a combination of two or more silane compounds in a desired ratio, as the aforementioned silane compound that functions as the monomer for forming the resin. When a combination of two or more silane compounds is used, the specific combination of compounds and the ratio between the compounds can be set according to need.

With the exception of using different raw materials, the condensation reaction can be performed using a similar method to that used for conventional silicone resins.

For example, the silicone resins described above can be obtained by reacting the monomer required for forming the silicone resin (namely, the aforementioned silane compound) in the presence of an acidic aqueous solution or a basic aqueous solution, using a solvent such as 2-propanol or methyl ethyl ketone when required, preferably at a temperature of 40 to 130°C, and preferably for a period of 1 to 48 hours. Following the reaction, a post-treatment such as washing may be performed as required, and the target product may then be extracted, or may be used in the intended application without extraction.

However, the method for producing the silicone resins is not limited to the method outlined here.

In the silicone resins described above and the cured products thereof, degradation caused by oxidation reactions is satisfactorily suppressed, and the cured products are, for example, ideal for use in applications that require resistance to oxidation reactions during ultraviolet irradiation. The cured products have particularly remarkable resistance to the irradiation of deep ultraviolet light in the wavelength region from at least 200 nm to not more than 300 nm.

The above silicone resins and cured products having these types of properties are ideal for encapsulating materials for semiconductor light-emitting elements, and can be used particularly favorably for encapsulating materials for UV- (ultraviolet-) LEDs (light-emitting diodes).

<Silicone resin composition, cured product>

The above silicone resins can be cured by heating to obtain cured products.

The cured product is obtained by curing a silicone resin composition containing the silicone resin and other components besides the silicone resin.

The amount of the silicone resin in the silicone resin composition may be adjusted appropriately in accordance with the intended application for the composition, but usually, is preferably at least 60% by mass, and more preferably at least 70% by mass, relative to the total mass of the silicone resin composition.

[Other components]

The silicone resin composition is a composition containing the silicone resin described above and other components besides the silicone resin, and these other components may be selected appropriately in accordance with the intended application.

For these other components, a single component may be used alone, or a combination of two or more components may be used, and when two or more components are combined, the specific combination of components and the ratio therebetween may be set as appropriate.

Preferred examples of the other components include curing catalysts, silane coupling agents, inorganic particles, phosphors, modifying silicone compounds, antifoaming agents and solvents.

The amount of these other components in the silicone resin composition may be adjusted appropriately in accordance with the intended application for the composition, but usually, the amount is preferably at least 5% by mass but not more than 40% by mass, and more preferably at least 10% by mass but not more than 30% by mass, relative to the total mass of the silicone resin composition.

(Curing catalyst)

There are no particular limitations on the curing catalyst, provided it is a curing catalyst capable of promoting the condensation reaction of the silicone resin.

Examples of the curing catalyst include inorganic acids and derivatives thereof such as hydrochloric acid, sulfuric acid, nitric acid and phosphoric acid-based compounds; organic acids such as formic acid, acetic acid, oxalic acid, citric acid, propionic acid, butyric acid, lactic acid and succinic acid; alkaline compounds such as ammonium hydroxide, tetramethylammonium hydroxide and tetraethylammonium hydroxide; and organometallic compounds such as organic complexes or organic acid salts containing at least one metal selected from the group consisting of tin (Sn), zinc (Zn), iron (Fe), titanium (Ti), zirconium (Zr), bismuth (Bi), hafnium (Hf), yttrium (Y), aluminum (Al), boron (B) and gallium (Ga) as a metal component.

In terms of exhibiting superior reactivity, the curing catalyst is preferably an aforementioned organometallic compound containing tin, titanium, zinc, zirconium, hafnium or gallium. Moreover, organometallic compounds containing zirconium, hafnium or gallium are particularly preferred as the curing catalyst in terms of exhibiting minimal electrode corrosion or light absorption when used in light-emitting devices, having an appropriate level of catalytic activity, and being unlikely to cause unnecessary degradation arising from cleavage of the polysiloxane chain.

Examples of the organometallic compounds containing tin include tetraalkyl tin, dialkyl tin oxide and dialkyl tin dicarbonate. In the dialkyl tin dicarbonate, the numbers of carbon atoms in the alkyl groups and the carboxylic acids are preferably from 1 to 10.

Examples of the organometallic compounds containing titanium include tetraalkoxy titanium, tetraalkoxy titanium oligomers and titanium acetylacetonate. The number of carbon atoms in the alkyl group of the tetraalkoxy titanium or tetraalkoxy titanium oligomer is preferably from 3 to 8.

Examples of the organometallic compounds containing zinc include zinc triacetylacetonate, zinc stearate and bis(acetylacetonato)zinc(II) (monohydrate).

Examples of the organometallic compounds containing zirconium include zirconium tetraacetylacetonate, zirconium dibutoxy diacetylacetonate, zirconium tetraalkoxide, zirconyl (2-ethylhexanoate) and zirconium (2-ethylhexanoate). The number of carbon atoms in the alkyl group of the zirconium tetraalkoxide is preferably from 3 to 8.

Examples of the organometallic compounds containing hafnium include compounds similar to the above organometallic compounds containing zirconium in which the metal has been replaced with hafnium (such as hafnium tetraacetylacetonate).

Examples of the organometallic compounds containing gallium include gallium triacetylacetonate, gallium trialkoxide, gallium octoate, gallium laurate and gallium acetate. The number of carbon atoms in the alkyl group of the gallium trialkoxide is preferably from 2 to 8.

For the inorganic acid or derivative thereof, phosphoric acid-based catalysts (phosphoric acid-based compounds) are preferable from the viewpoints of miscibility with the silicone components and the curing promotion properties.

Examples of the phosphoric acid-based compounds include compounds represented by general formula (Z1) or (Z2) shown below.

[Chemical formula 4]

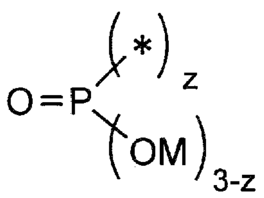

(Z 1)

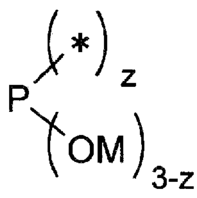

(Z 2)

(In the formulas, M represents a counter cation, * represents another atom or atom grouping, and z is an integer of 0 to 2. When a plurality of M exists, the plurality of M moieties may be the same or different, and when a plurality of * exists, the plurality of * moieties may be the same or different.)

An example of the above counter cation for M is a hydrogen ion.

Examples of the other atom or atom grouping represented by * include atoms or atom groupings represented by general formula "OG" or "G" (wherein, G represents a monovalent organic group).

Examples of the monovalent organic group include a methyl group, ethyl group, methoxy group and ethoxy group.

Specific examples of the phosphoric acid-based compound include phosphoric acid, phosphorous acid, phosphate esters and phosphite esters.

In order to enable the curing catalyst to be added to the silicone resin composition in a prescribed concentration, the curing catalyst may be added to the silicone resin composition in a dilute state within an organic solvent or a silicone monomer or silicone oligomer or the like that is easily blended with the silicone resin composition. The silicone monomer or silicone oligomer mentioned here is different from the fluorine atom-containing silane compound (1) and the fluorine atom-containing silane compound (2) described above.

A single curing catalyst may be used alone, or a combination of two or more curing catalysts may be used, and when two or more curing catalysts are combined, the combination of catalysts and the ratio therebetween may be set as appropriate.

Further, the curing catalyst may also be used in combination with a reaction promoter or a reaction inhibitor.

The amount of the curing catalyst in the silicone resin composition may be set as appropriate with due consideration of factors such as the heating temperature during the curing reaction, the reaction time and the type of curing catalyst. For example, the amount of the curing catalyst is preferably from 0.001 to 3.0% by mass, and more preferably from 0.001 to 1.5% by mass, relative to the amount of the silicone resin.

When an aforementioned organometallic compound is used as the curing catalyst, the amount of the curing catalyst in the silicone resin composition, calculated as the equivalent mass of metal atoms, is preferably from 0.001 to

0.5% by mass, and more preferably from 0.003 to 0.2% by mass, relative to the amount of the silicone resin. The amount of the organometallic compound can be measured by high-frequency inductively coupled plasma (ICP) analysis of the catalyst metal component.

When an aforementioned phosphoric acid-based compound is used as the curing catalyst, the amount of the curing catalyst in the silicone resin composition is preferably from 0.1 to 3.0% by mass, and more preferably from 0.2 to 1.5% by mass, relative to the amount of the silicone resin.

The curing catalyst may be added to the silicone resin composition immediately prior to performing the curing reaction, or may be included in the original silicone resin composition together with the other components besides the curing catalyst.

(Silane coupling agent)

Silane coupling agents have the effect of improving the adhesion between the cured product and the application target object (such as a semiconductor light-emitting element or package).

Examples of the silane coupling agent include silane coupling agents having at least one group selected from the group consisting of an ethenyl group (vinyl group), epoxy group, styryl group, (meth)acrylic group, amino group, ureido group, mercapto group, sulfide group and isocyanate group, and of these, coupling agents having an epoxy group or a mercapto group are preferred. Specific examples of these preferred silane coupling agents include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, 3-mercaptopropylmethyldimethoxysilane and 3-mercaptopropyltrimethoxysilane.

In this description, "(meth)acrylic group" is a generic term that includes both an acrylic group and a methacrylic group.

The amount of the silane coupling agent in the silicone resin composition is preferably from 0.0001 to 1.0 parts by mass, and more preferably from 0.001 to 0.5 parts by mass, per 100 parts by mass of the solid fraction of the silicone resin composition.

The silane coupling agent may be used by mixing into the silicone resin composition, or may be applied in advance, by coating or an immersion treatment, to the surface of the application target object (such as a semiconductor light-emitting element or package) for the cured product of the silicone resin composition, with the silicone resin composition then being formed and cured by potting or the like.

(Inorganic particles)

By including inorganic particles and a phosphor in the silicone resin composition, the aforementioned cured product (encapsulating material) is, for example, able to enhance the intensity of light from a light-emitting element.

The inorganic particles have a function of scattering light inside the cured product (namely, the encapsulating material), thereby effectively exciting the phosphor, a function of preventing the phosphor from settling down through the silicone resin composition, a function of adjusting the viscosity of the silicone resin composition, and a function of improving the light scattering properties, refractive index, dimensional stability and mechanical strength of the cured product (namely, the encapsulating material).

Examples of the inorganic particles include oxides of silicon, titanium, zirconium, aluminum, iron and zinc and the like, carbon black, barium titanate, calcium silicate and calcium carbonate. Among these, silicon oxides, titanium oxides and aluminum oxides are preferred as the inorganic particles, and in terms of achieving low absorption of UV light, silicon oxides and aluminum oxides are particularly preferred.

Examples of the form of the inorganic particles include spherical, plate-like, columnar, needle-like, whisker-like and fibrous particles.

The material for the inorganic particles may be a single material or a combination of two or more materials, and when two or more materials are combined, the specific combination of materials and the ratio between the materials can be set according to need.

Further, the inorganic particles preferably contain inorganic particles having two or more different particle sizes, and more preferably contain at least two types of particles including inorganic particles having a primary particle average particle size of 100 to 500 nm and inorganic particles having a primary particle average particle size of less than 100 nm. By including two or more types of inorganic particles having different primary particle average particle sizes, the efficiency of the excitation of the phosphor by scattered light in the cured product (encapsulating material) can be further improved, and the effect of the inorganic particles in preventing settling of the phosphor also improves.

The primary particle average particle size can be determined, for example, by an imaging method or the like in which an electron microscope or the like is used to view the particles directly. Specifically, a sample prepared by placing the inorganic particles to be measured into an arbitrary solvent, performing irradiation with ultrasound or the like

to thoroughly disperse the particles, and then dripping the dispersion onto a slide glass or the like and performing drying, or a sample prepared by adhering the inorganic particles directly to the adhesive surface of an adhesive tape by sprinkling the particles onto the tape, is inspected using a scanning electron microscope (SEM) or a transmission electron microscope (TEM) or the like, and the primary particle average particle size is then determined by calculating the dimensions of the particles from the particle shapes. For example, the projected area of an inorganic particle may be determined, and the diameter of a circle corresponding with that area then calculated and recorded as the particle size. In this case, the particle size is determined for at least 100 particles (and preferably 100 particles), and the arithmetic mean may then be calculated and recorded as the average particle size.

Although there are no particular limitations on the amount of inorganic particles in the silicone resin composition, the amount of inorganic particles is, for example, preferably from 0.01 to 10% by mass, and more preferably from 0.1 to 5% by mass, relative to the amount of the silicone resin.

(Phosphor)

There are no particular limitations on the phosphor, and examples include red phosphors that emit fluorescence in a wavelength range from 570 to 700 nm, green phosphors that emit fluorescence in a wavelength range from 490 to 570 nm, and blue phosphors that emit fluorescence in a wavelength range from 420 to 480 nm. Further, a plurality of phosphors may also be combined, depending on the brightness or color required.

There are no particular limitations on the amount of phosphor in the silicone resin composition, and the amount may be adjusted appropriately with due consideration of the properties of the application target object, such as the amount of light emitted by the light-emitting element, or the color and brightness required as a semiconductor light-emitting device.

When the inorganic particles and phosphor described above are added to the silicone resin composition, because the phosphor is prone to settling, it is preferable that the inorganic particles are added first, the phosphor is then added to complete the silicone resin composition, and the composition is then used promptly for encapsulating the application target object (such as a semiconductor light-emitting element).

Although there are no particular limitations on the amount of the phosphor in the silicone resin composition, the amount is preferably from 1 to 50% by mass, and more preferably from 5 to 40% by mass, relative to the amount of the silicone resin.

(Modifying silicone compound)

Examples of the modifying silicone compound include silicone compounds that do not correspond with the silicone resins described above, such as dimethyl silicone oils, amino silicones and epoxy silicones, and typical commercially available products may be used. By using a modifying silicone compound, for example, flexibility can be imparted to the cured product.

The amount of such modifying silicone compounds in the silicone resin composition is preferably from 0.1 to 20 parts by mass (solid fraction), and more preferably from 0.5 to 10 parts by mass, per 100 parts by mass of the solid fraction of the silicone resin composition.

(Antifoaming agent)

The antifoaming agent suppresses gas bubble formation during mixing of the silicone resin composition. The amount of the antifoaming agent in the silicone resin composition is preferably from 0.01 to 3 parts by mass (solid fraction), and more preferably from 0.01 to 1 part by mass, per 100 parts by mass of the solid fraction of the silicone resin composition.

(Solvent)

There are no particular limitations on the solvent, and any of various solvents such as organic solvents may be used.

A single solvent may be used alone, or a combination of two or more solvents may be used, and when two or more solvents are combined, the specific combination of solvents and the ratio therebetween may be set as appropriate.

During production of the silicone resin composition, when the various components are added, in terms of enabling more uniform mixing of the components and improving the stability of the resulting resin solution, it is preferable that the components other than the solvent are first dissolved in an organic solvent having high levels of volatility and dissolution, and the solvent is then substituted with another solvent. Specifically, first, one or more components are added to an organic solvent having high volatility (hereinafter also referred to as the "organic solvent P"), and are

dissolved by heating and stirring the solvent at a temperature close to the boiling point of the organic solvent P. Next, the operation of adding one or more additional components as required and dissolving the components in a similar manner to that described above is repeated at least once. Subsequently, a solvent (hereinafter also referred to as the "solvent Q") having lower volatility than the organic solvent P is added, and a solvent substitution from the organic solvent P to the solvent Q can be performed by heating the solution until the concentration of the organic solvent P falls to 1% or less. In order to facilitate a more efficient solvent substitution, heating may be performed with the inside of the vessel under a state of reduced pressure (for example, about 20 hPa).

By performing this type of treatment, residual solvent used during synthesis of the various components and not completely removed, and unreacted residual water or the like can also be removed during the solvent substitution, thereby improving the stability of the resin solution.

The organic solvent P is preferably an organic solvent having a boiling point of less than 100°C. Examples of this type of organic solvent P include ketones such as acetone and methyl ethyl ketone; alcohols such as methanol, ethanol, 1-propanol and 2-propanol; aliphatic hydrocarbons such as hexane, heptane and cyclohexane; aromatic hydrocarbons such as benzene; esters such as methyl acetate and ethyl acetate; and ethers such as dimethyl ether and tetrahydrofuran.

The solvent Q is preferably an organic solvent having a boiling point of 100°C or higher. Examples of this type of solvent Q include glycol ethers such as ethylene glycol monomethyl ether, ethylene glycol monoethyl ether, ethylene glycol monoisopropyl ether, ethylene glycol monobutyl ether, ethylene glycol monohexyl ether, ethylene glycol monoethylhexyl ether, ethylene glycol monophenyl ether, ethylene glycol monobenzyl ether, diethylene glycol monomethyl ether, diethylene glycol monoethyl ether, diethylene glycol monoisopropyl ether, diethylene glycol monobutyl ether, diethylene glycol monohexyl ether, diethylene glycol monoethylhexyl ether, diethylene glycol monophenyl ether, diethylene glycol monobenzyl ether, propylene glycol monomethyl ether, propylene glycol monoethyl ether, propylene glycol monoisopropyl ether, propylene glycol monobutyl ether, propylene glycol monohexyl ether, propylene glycol monoethylhexyl ether, propylene glycol monophenyl ether, propylene glycol monobenzyl ether, dipropylene glycol monomethyl ether, dipropylene glycol monoethyl ether, dipropylene glycol monoisopropyl ether, dipropylene glycol monobutyl ether, dipropylene glycol monohexyl ether, dipropylene glycol monoethylhexyl ether, dipropylene glycol monophenyl ether and dipropylene glycol monobenzyl ether; glycol esters in which one of the above glycol ethers has been acetate-esterified, such as ethylene glycol monoethyl ether acetate, ethylene glycol monoisopropyl ether acetate, ethylene glycol monobutyl ether acetate, ethylene glycol monohexyl ether acetate, ethylene glycol monoethylhexyl ether acetate, ethylene glycol monophenyl ether acetate and ethylene glycol monobenzyl ether acetate; and ketones such as methyl isobutyl ketone.

Among these, ethylene glycol monobutyl ether acetate and methyl isobutyl ketone are preferred.

The solvent is usually selected so that the boiling point of the resulting liquid silicone resin composition is preferably from 40 to 250°C, and more preferably from 100 to 230°C.

There are no particular limitations on the amount of the solvent (for example, the solvent Q) in the silicone resin composition, and the amount may be adjusted appropriately in accordance with the intended purpose, but usually the amount is preferably at least 10% by mass but not more than 30% by mass, relative to the total mass of the silicone resin composition.

The resin solution obtained in the production of the aforementioned silicone resin may be used, as is, as the silicone resin composition, if necessary following a post-treatment such as washing.

[Method for producing silicone resin composition]

The silicone resin composition can be produced by blending the silicone resin and the other components besides the silicone resin.

There are no particular limitations on the blending method used at this time, and the sequence in which each of the components are added and the mixing method used following this addition may be adjusted as appropriate. For example, the mixing method may be selected as appropriate from conventional mixing methods such as methods in which mixing is performed by rotating a stirring bar or stirring blade, mixing methods using a mixer or a beads mill or the like, and methods in which mixing is performed by ultrasonic irradiation. A preferred blending method for the case where the organic solvent P and solvent Q are used is as described above.

The silicone resin composition can be used favorably for encapsulating semiconductor light-emitting elements, reflecting the properties of the silicone resin contained within the composition, and for example, is particularly ideal as an encapsulating material for UV- (ultraviolet-) LEDs (light-emitting diodes) (namely, as an encapsulating material composition for UV-LEDs).

In other words, one aspect of an encapsulating material composition for UV-LEDs that represents one embodiment of the present invention contains the aforementioned silicone resin, and another component besides the silicone resin, wherein

the other component includes at least one component selected from the group consisting of curing catalysts, silane

coupling agents, inorganic particles, phosphors, modifying silicone compounds, antifoaming agents and solvents.

Moreover, in the above encapsulating material composition for UV-LEDs, the amount of the silicone resin is preferably at least 60% by mass but not more than 95% by mass, relative to the total mass of the encapsulating material composition for UV-LEDs, and
the amount of the other component is preferably at least 70% by mass but not more than 90% by mass, relative to the total mass of the encapsulating material composition for UV-LEDs,
provided that the total of the amount of the silicone resin and the amount of the other component does not exceed 100% by mass.

[Cured product and method for producing same]

The aforementioned cured product can be produced by heating and curing the aforementioned silicone resin or silicone resin composition.

The heating temperature during curing can be set, for example, to 40 to 250°C, and the heating time can be set, for example, to 1 to 24 hours, but the invention is not limited to these ranges.

Further, during curing, in order to remove solvents and water that exist in the silicone resin composition, and better control the rate of the condensation reaction of the silicone resin, the heating temperature may be increased in a stepwise manner, thereby performing curing in a stepwise manner.

The specific gravity of the cured product is preferably from 1.0 to 1.4, and more preferably from 1.1 to 1.3.

The specific gravity of the cured product can generally be determined from the volume and the mass. When the shape of the cured product is irregular, the specific gravity can be measured by the Archimedes method using a commercially available specific gravity measurement device.

One aspect of the present invention is a cured product of the aforementioned silicone resin or silicone resin composition.

Another aspect is a cured product obtained by heating the silicone resin or silicone resin composition at a temperature of 40 to 250°C for 1 to 24 hours.

In yet another aspect of the present invention, the specific gravity of the cured product is from 1.0 to 1.4.

In yet another aspect of the present invention, the cured product has the following property. Specifically, when the transmittance of light of wavelength 400 nm and 350 nm through a cured product with a thickness of 1 mm following heating of the cured product in an oven at 200°C for 60 hours is compared with the same light transmittance prior to the heating, the change in the transmittance is not more than 10%.

In yet another aspect of the present invention, the cured product has the following property. Specifically, when the transmittance of light of wavelength 400 nm and 350 nm through a cured product with a thickness of 1 mm following irradiation of the cured product with UV light of wavelength 350 nm for 100 hours is compared with the same light transmittance prior to the irradiation, the change in the transmittance is not more than 10%.

In yet another aspect of the present invention, the cured product has the following property. Specifically, when the cured product is heated on a hotplate to 100°C and is then irradiated with UV light of wavelength 350 nm for 50 hours, the change in the value of [peak intensity in infrared absorption spectrum of peak attributable to Si-CH] / [peak intensity in infrared absorption spectrum of peak attributable to Si-O-Si] relative to the value of [peak intensity in infrared absorption spectrum of peak attributable to Si-CH] / [peak intensity in infrared absorption spectrum of peak attributable to Si-O-Si] prior to the heating and UV irradiation is not more than 10%.

The cured product reflects the properties of the silicone resin used, and is able to satisfactorily suppress degradation caused by oxidation reactions, as well as suppressing cracking, degeneration and decomposition, and can therefore be used favorably as an encapsulating material for semiconductor light-emitting elements, and is particularly ideal as an encapsulating material for UV- (ultraviolet-) LEDs (light-emitting diodes).

One aspect of the present invention is an encapsulating material for UV-LEDs containing a cured product of the aforementioned silicone resin or silicone resin composition.

Another aspect of the present invention is an encapsulating material for UV-LEDs formed from a cured product obtained by heating the aforementioned silicone resin or silicone resin composition at 40 to 250°C for 1 to 24 hours.

In yet another aspect of the present invention, the specific gravity of the encapsulating material is from 1.0 to 1.4.

<Semiconductor light-emitting device>

An example of a semiconductor light-emitting device that uses the above cured product as an encapsulating material includes a substrate, a semiconductor light-emitting element disposed on the substrate, and an encapsulating portion provided covering the surface of the semiconductor light-emitting element, wherein the periphery of the semiconductor light-emitting element is enclosed and encapsulated by the substrate and the encapsulating portion, a material containing the aforementioned cured product may be used as the material for forming the encapsulating portion, and

the material for forming the encapsulating portion is preferably composed of the cured product.

The above semiconductor light-emitting device is preferably a device in which the semiconductor light-emitting element is encapsulated with a cured product of the silicone resin composition described above (namely, an encapsulating material composition for a semiconductor light-emitting element).

In other words, one aspect of a semiconductor light-emitting device according to the present invention contains a substrate, a semiconductor light-emitting element disposed on the substrate, and an encapsulating portion for the semiconductor light-emitting element, wherein

the periphery of the semiconductor light-emitting element is enclosed and encapsulated by the substrate and the encapsulating portion, and

the encapsulating portion contains a cured product of the aforementioned silicone resin or a cured product of the aforementioned silicone resin composition.

FIG. 1 is a cross-sectional view schematically illustrating one example of the above semiconductor light-emitting device.

The semiconductor light-emitting device 100 illustrated here includes a substrate 110, a semiconductor light-emitting element 120 disposed on the substrate, and an encapsulating portion 130 that encapsulates the semiconductor light-emitting element 120. The material for forming the encapsulating portion 130 is an encapsulating material for a semiconductor light-emitting element composed of a cured product of the silicone resin composition described above. The semiconductor light-emitting element 120 is covered and encapsulated by the substrate 110 and the encapsulating portion 130, and is thus isolated from the external atmosphere.

The encapsulating portion 130 contains a cured product of the aforementioned silicone resin or a cured product of the silicone resin composition. The encapsulating portion 130 has no discontinuous surfaces in the direction perpendicular to the substrate 110. The existence or absence of discontinuous surfaces can be ascertained, for example, by performing an X-Ray CT measurement. In an X-ray CT measurement, because the scattering intensity differs depending on the electron density, a discontinuous surface within the material is observed as a different shade in the CT image.

Because it is formed using the silicone resin described above, the encapsulating portion 130 exhibits satisfactorily superior resistance to oxidation reactions and good suppression of cracking, degeneration and decomposition and the like, and therefore the encapsulating effect on the semiconductor light-emitting element is extremely favorable.

Further, because the encapsulating portion 130 exhibits superior light transmittance and superior light extraction efficiency, and also has satisfactory resistance to oxidation reactions, deterioration in the light transmittance and discoloration over time are also suppressed.

A preferred example of the semiconductor light-emitting device is a UV light-emitting device.

EXAMPLES

The present invention is described below in further detail using a series of specific examples. However, the present invention is in no way limited by the following examples. In the following description, "THF" means tetrahydrofuran.

The specific gravity values for the cured products of the silicone resins in the following examples and comparative examples can be calculated by the following formula, using the various measurement values obtained under the following conditions.

<Method for measuring specific gravity of cured product of silicone resin>

Apparatus name: Electronic specific gravity meter MDS-300 manufactured by Alfa Mirage Co., Ltd.
Liquid used: water
Measurement temperature: 24°C
Calculation formula: $p = A/(A-B)\times\rho 0$

(In the formula, p represents the specific gravity (g/cm$^3$) of the cured product, A represents the mass (g) of the cured product in the open air, B represents the mass (g) of the cured product in a liquid, and $\rho$0 represents the specific gravity (g/cm$^3$) of the liquid.)

<Production of silicone resin and cured product thereof in which all of the fluoroalkyl groups bonded to silicon atoms are partially fluorinated alkyl groups>

[Example 1]

A flask placed in an oil bath was charged with trimethoxy(3,3,3-trifluoropropyl)silane (4.8 g, manufactured by Tokyo Chemical Industry Co., Ltd.), 2-propanol (7.1 g) and deionized water (1.0 g), and the resulting mixture was stirred at room temperature until a uniform solution was obtained. Subsequently, a 5% by mass aqueous solution of hydrochloric acid (0.7 g) was added dropwise, and following stirring for 10 minutes, the temperature was raised to 50°C, stirring was performed at 50°C for 30 minutes, the temperature was then further raised to 80°C, and stirring was continued at 80°C for 18 hours, thus obtaining a solution of a condensation product (polymer) having a structure represented by the formula shown below.

Subsequently, this solution (0.45 g) was placed in an aluminum cup, the cup was placed in an oven, and the temperature was raised from room temperature to 150°C at a rate of 5°C/minute and then held at 150°C for 10 hours, thus obtaining a cured product of the condensation product (polymer).

[Chemical formula 5]

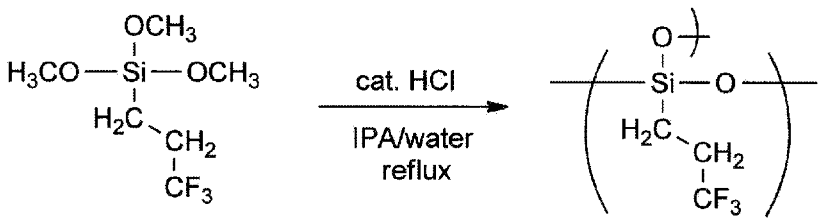


<Production of silicone resins in which all of the fluoroalkyl groups bonded to silicon atoms are partially fluorinated alkyl groups>

[Example 2]

A flask of capacity 1 L fitted with a stirrer, a reflux column, a dropping funnel and a nitrogen gas bubbling device was charged with methyl isobutyl ketone (300 g), methyltrimethoxysilane (17.0 g, 0.125 mol) and trimethoxy(3,3,3-trifluoropropyl)silane (81.8 g, 0.375 mol), and ion-exchanged water (36 g) was then added dropwise to the flask at room temperature. Subsequently, 100 ppm of hydrochloric acid was added as a reaction catalyst, the resulting mixture was heated to the reflux temperature of the methyl isobutyl ketone (118°C) while nitrogen gas was bubbled through the mixture, and the reaction was then allowed to proceed for two hours to obtain a condensation product (polymer). During the reaction, a water quantification receiver was fitted to the reflux column, and the water of condensation produced as a by-product of the condensation reaction (polymerization reaction) was removed. The thus obtained condensation product was washed 5 times with ion-exchanged water, and the methyl isobutyl ketone was then removed using an evaporator, yielding the target silicone resin.

[Chemical formula 6]

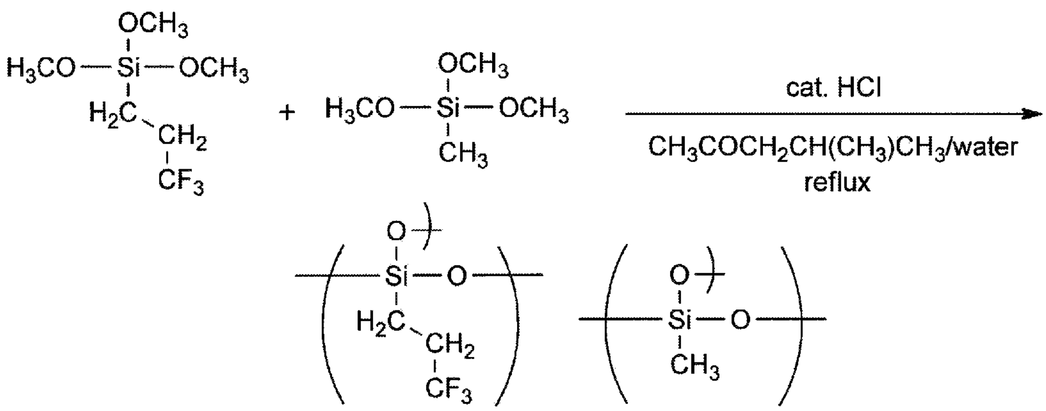


[Example 3]

A flask of capacity 1 L fitted with a stirrer, a reflux column, a dropping funnel and a nitrogen gas bubbling device was charged with methyl isobutyl ketone (300 g), methyltrimethoxysilane (34.1 g, 0.25 mol) and trimethoxy(3,3,3-trifluoropropyl)silane (54.6 g, 0.25 mol), and ion-exchanged water (36 g) was then added dropwise to the flask at room temperature. Subsequently, 100 ppm of hydrochloric acid was added as a reaction catalyst, the resulting mixture was heated to the reflux temperature of the methyl isobutyl ketone (118°C) while nitrogen gas was bubbled through the mixture, and the reaction was then allowed to proceed for two hours to obtain a condensation product (polymer). During the reaction, a water quantification receiver was fitted to the reflux column, and the water of condensation produced as a by-product of the condensation reaction (polymerization reaction) was removed. The thus obtained condensation product was washed 5 times with ion-exchanged water, and the methyl isobutyl ketone was then removed using an evaporator, yielding the target silicone resin.

[Example 4]

A flask of capacity 1 L fitted with a stirrer, a reflux column, a dropping funnel and a nitrogen gas bubbling device was charged with methyl isobutyl ketone (300 g), methyltrimethoxysilane (51.1 g, 0.375 mol) and trimethoxy(3,3,3-trifluoropropyl)silane (27.3 g, 0.125 mol), and ion-exchanged water (36 g) was then added dropwise to the flask at room temperature. Subsequently, 100 ppm of hydrochloric acid was added as a reaction catalyst, the resulting mixture was heated to the reflux temperature of the methyl isobutyl ketone (118°C) while nitrogen gas was bubbled through the mixture, and the reaction was then allowed to proceed for two hours to obtain a condensation product (polymer). During the reaction, a water quantification receiver was fitted to the reflux column, and the water of condensation produced as a by-product of the condensation reaction (polymerization reaction) was removed. The thus obtained condensation product was washed 5 times with ion-exchanged water, and the methyl isobutyl ketone was then removed using an evaporator, yielding the target silicone resin.

<Production of silicone resins in which all of the fluoroalkyl groups bonded to silicon atoms are perfluoroalkyl groups>

[Example 5]

A flask of capacity 1 L fitted with a stirrer, a reflux column, a dropping funnel and a nitrogen gas bubbling device was charged with methyl isobutyl ketone (300 g) and trifluoromethyltrimethoxysilane (95 g, 0.5 mol), and ion-exchanged water (36 g) was then added dropwise to the flask at room temperature. Subsequently, 100 ppm of hydrochloric acid was added as a reaction catalyst, the resulting mixture was heated to the reflux temperature of the methyl isobutyl ketone (118°C) while nitrogen gas was bubbled through the mixture, and the reaction was then allowed to proceed for two hours to obtain a condensation product (polymer). During the reaction, a water quantification receiver was fitted to the reflux column, and the water of condensation produced as a by-product of the condensation reaction (polymerization reaction) was removed. The thus obtained condensation product was washed 5 times with ion-exchanged water, and the methyl isobutyl ketone was then removed using an evaporator, yielding the target silicone resin.

[Chemical formula 7]

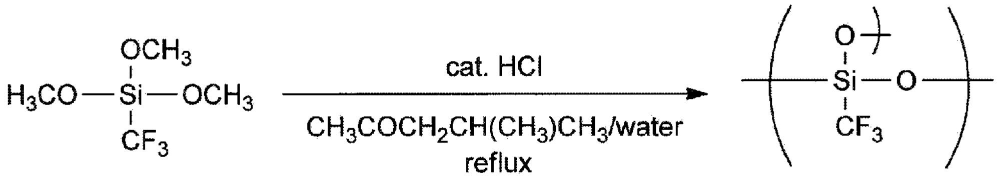


[Example 6]

A flask of capacity 1 L fitted with a stirrer, a reflux column, a dropping funnel and a nitrogen gas bubbling device was charged with methyl isobutyl ketone (300 g), methyltrimethoxysilane (17.0 g, 0.125 mol) and trifluoromethyltrimethoxysilane (71.3 g, 0.375 mol), and ion-exchanged water (36 g) was then added dropwise to the flask at room temperature. Subsequently, 100 ppm of hydrochloric acid was added as a reaction catalyst, the resulting mixture was heated to the reflux temperature of the methyl isobutyl ketone (118°C) while nitrogen gas was bubbled through the mixture, and the reaction was then allowed to proceed for two hours to obtain a condensation product (polymer). During the reaction, a water quantification receiver was fitted to the reflux column, and the water of condensation produced as a by-product of the condensation reaction (polymerization reaction) was removed. The thus obtained condensation product was washed 5 times with ion-exchanged water, and the methyl isobutyl ketone was then removed using an evaporator, yielding the target silicone resin.

[Chemical formula 8]

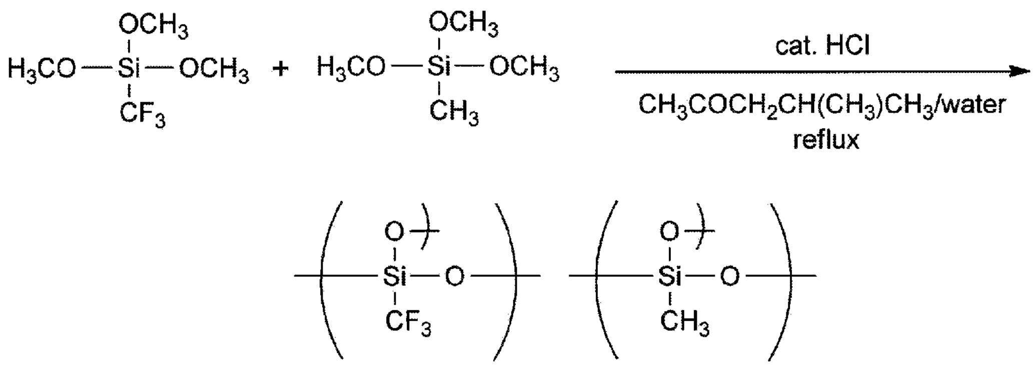


[Example 7]

A flask of capacity 1 L fitted with a stirrer, a reflux column, a dropping funnel and a nitrogen gas bubbling device was charged with methyl isobutyl ketone (300 g), methyltrimethoxysilane (34.1 g, 0.25 mol) and trifluoromethyltrimethoxysilane (47.5 g, 0.25 mol), and ion-exchanged water (36 g) was then added dropwise to the flask at room temperature. Subsequently, 100 ppm of hydrochloric acid was added as a reaction catalyst, the resulting mixture was heated to the reflux temperature of the methyl isobutyl ketone (118°C) while nitrogen gas was bubbled through the mixture, and the reaction was then allowed to proceed for two hours to obtain a condensation product (polymer). During the reaction, a water quantification receiver was fitted to the reflux column, and the water of condensation produced as a by-product of the condensation reaction (polymerization reaction) was removed. The thus obtained condensation product was washed 5 times with ion-exchanged water, and the methyl isobutyl ketone was then removed using an evaporator, yielding the target silicone resin.

[Example 8]

A flask of capacity 1 L fitted with a stirrer, a reflux column, a dropping funnel and a nitrogen gas bubbling device

was charged with methyl isobutyl ketone (300 g), methyltrimethoxysilane (51.1 g, 0.375 mol) and trifluoromethyltrimethoxysilane (23.8 g, 0.125 mol), and ion-exchanged water (36 g) was then added dropwise to the flask at room temperature. Subsequently, 100 ppm of hydrochloric acid was added as a reaction catalyst, the resulting mixture was heated to the reflux temperature of the methyl isobutyl ketone (118°C) while nitrogen gas was bubbled through the mixture, and the reaction was then allowed to proceed for two hours to obtain a condensation product (polymer). During the reaction, a water quantification receiver was fitted to the reflux column, and the water of condensation produced as a by-product of the condensation reaction (polymerization reaction) was removed. The thus obtained condensation product was washed 5 times with ion-exchanged water, and the methyl isobutyl ketone was then removed using an evaporator, yielding the target silicone resin.

[Example 9]

A flask of capacity 1 L fitted with a stirrer, a reflux column, a dropping funnel and a nitrogen gas bubbling device was charged with methyl isobutyl ketone (300 g), di(trifluoromethyl)dimethoxysilane (28.5 g, 0.125 mol) and trifluoromethyltrimethoxysilane (71.3 g, 0.375 mol), and ion-exchanged water (36 g) was then added dropwise to the flask at room temperature. Subsequently, 100 ppm of hydrochloric acid was added as a reaction catalyst, the resulting mixture was heated to the reflux temperature of the methyl isobutyl ketone (118°C) while nitrogen gas was bubbled through the mixture, and the reaction was then allowed to proceed for two hours to obtain a condensation product (polymer). During the reaction, a water quantification receiver was fitted to the reflux column, and the water of condensation produced as a by-product of the condensation reaction (polymerization reaction) was removed. The thus obtained condensation product was washed 5 times with ion-exchanged water, and the methyl isobutyl ketone was then removed using an evaporator, yielding the target silicone resin.

[Chemical formula 9]

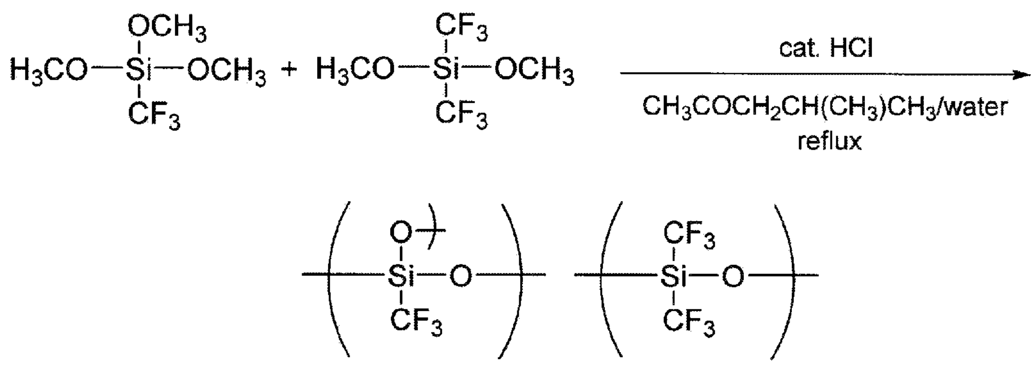


[Example 10]

A flask of capacity 1 L fitted with a stirrer, a reflux column, a dropping funnel and a nitrogen gas bubbling device was charged with methyl isobutyl ketone (300 g), di(trifluoromethyl)dimethoxysilane (57.0 g, 0.25 mol) and trifluoromethyltrimethoxysilane (47.5 g, 0.25 mol), and ion-exchanged water (36 g) was then added dropwise to the flask at room temperature. Subsequently, 100 ppm of hydrochloric acid was added as a reaction catalyst, the resulting mixture was heated to the reflux temperature of the methyl isobutyl ketone (118°C) while nitrogen gas was bubbled through the mixture, and the reaction was then allowed to proceed for two hours to obtain a condensation product (polymer). During the reaction, a water quantification receiver was fitted to the reflux column, and the water of condensation produced as a by-product of the condensation reaction (polymerization reaction) was removed. The thus obtained condensation product was washed 5 times with ion-exchanged water, and the methyl isobutyl ketone was then removed using an evaporator, yielding the target silicone resin.

[Example 11]

A flask of capacity 1 L fitted with a stirrer, a reflux column, a dropping funnel and a nitrogen gas bubbling device was charged with methyl isobutyl ketone (300 g), di(trifluoromethyl)dimethoxysilane (85.6g, 0.375 mol) and trifluoromethyltrimethoxysilane (23.8 g, 0.125 mol), and ion-exchanged water (36 g) was then added dropwise to the flask at room temperature. Subsequently, 100 ppm of hydrochloric acid was added as a reaction catalyst, the resulting mixture was

heated to the reflux temperature of the methyl isobutyl ketone (118°C) while nitrogen gas was bubbled through the mixture, and the reaction was then allowed to proceed for two hours to obtain a condensation product (polymer). During the reaction, a water quantification receiver was fitted to the reflux column, and the water of condensation produced as a by-product of the condensation reaction (polymerization reaction) was removed. The thus obtained condensation product was washed 5 times with ion-exchanged water, and the methyl isobutyl ketone was then removed using an evaporator, yielding the target silicone resin.

[Comparative Example 1]

A silicone resin X1 represented by general formula (A) shown below and a silicone resin X2 represented by general formula (B) shown below were mixed in a ratio of silicone resin X1 : silicone resin X2 = 1:4 (mass ratio), and a catalyst containing platinum was added to the mixture to obtain a silicone resin composition. The weight-average molecular weight of the silicone resin X1 was 5,100 when measured under the GPC measurement conditions 1 described below. Further, the weight-average molecular weight of the silicone resin X2 was 2,100 when measured under the GPC measurement conditions 2 described below.

Of the total signal attributable to the silicon atoms of the obtained silicone resin composition, the signal surface area attributable to silicon atoms having three oxygen atoms bonded to the silicon atom (A3 silicon atoms) was calculated as 50% from the mixing ratio between the silicone resin X1 and the silicone resin X2.

Subsequently, the silicone resin composition (about 5 g) was placed in an aluminum cup, the cup was placed in an oven, and the temperature was raised from room temperature to 150°C at a rate of 5°C/minute and then held at 150°C for 4 hours, thus obtaining a cured product of the silicone resin composition. The thus obtained cured product had a specific gravity of 1.18.

[Chemical formula 10]

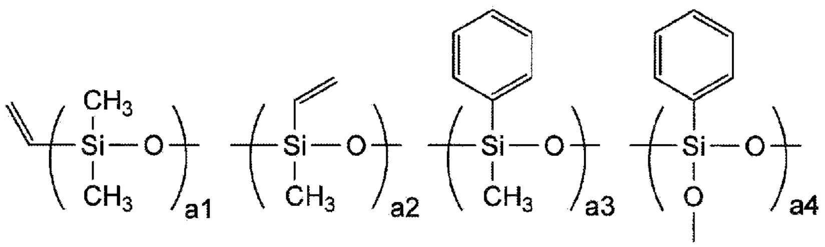

· · · · (A)

(In the formula, a1, a2, a3 and a4 are integers representing the number of units of each of the repeating units.)

[Chemical formula 11]

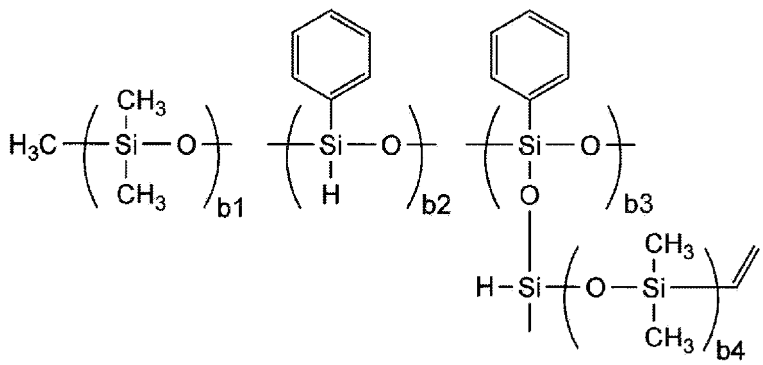

· · · · (B)

(In the formula, b1, b2, b3 and b4 are integers representing the number of units of each of the repeating units.)

<GPC measurement conditions for silicone resins>

(GPC measurement conditions 1)

Apparatus: HLC-8220 manufactured by Tosoh Corporation
Columns: TSKgel Multipore HXL-M × 3 columns + Guard column-MP (XL)
Flow rate: 1.0 mL/minute
Detection conditions: RI (polarity +)
Concentration: 100 mg + 5 mL (THF)
Injection volume: 100 μL
Column temperature: 40°C
Eluent: THF

(GPC measurement conditions 2)

Apparatus: HLC-8220 manufactured by Tosoh Corporation
Columns: TSKgel G2000HHR × 2 columns + G1000HHR × 2 columns
Flow rate: 1.0 mL/minute
Detection conditions: RI (polarity -)
Concentration: 100 mg + 5 mL (THF)
Injection volume: 200 μL
Column temperature: 40°C
Eluent: THF

<Evaluation of silicone resin cured products>

By using the methods described below to evaluate the heat resistance and light resistance of the cured products of the silicone resins and silicone resin compositions obtained above, the resistance to oxidation can be evaluated.

(Evaluation of heat resistance)

Using a solution of the condensation product (polymer) or the silicone resin composition obtained in each example and comparative example, and adjusting the amount used to achieve a cured product with a thickness of 1 mm, the solution or composition was placed in an aluminum cup, the cup was placed in an oven, and the temperature was raised from room temperature to 150°C at a rate of 5°C/minute and then held at 150°C for 10 hours, thus obtaining a cured product of the condensation product (polymer) or the silicone resin composition.
Subsequently, the thus obtained cured product was removed from the aluminum cup, and the transmittance of light of wavelength 400 nm and 350 nm through the cured product was measured.
Subsequently, the cured product was subjected to a heat treatment by standing for 60 hours in an oven at 200°C, and following removal from the oven and cooling to room temperature, the transmittance of light of wavelength 400 nm and 350 nm was remeasured.
The light transmittance and the external appearance of the cured product before and after the heat treatment were compared.

(Evaluation of light resistance)

Using a similar method to that described above for the evaluation of the heat resistance, a cured product was obtained from a solution of the condensation product (polymer) or the silicone resin composition, and the transmittance of light of wavelength 400 nm and 350 nm through the cured product was measured.
Subsequently, the cured product was subjected to a light irradiation treatment by irradiating UV light (230 to 450 nm) onto the cured product for 100 hours using a UV irradiation device SP-9 manufactured by Ushio Inc., and the transmittance of light of wavelength 400 nm and 350 nm was then remeasured.
The light transmittance and the external appearance of the cured product before and after the light irradiation treatment were compared.

The above evaluations of heat resistance revealed that following the heat treatment at 200°C, the cured products of the silicone resins obtained in each of the examples exhibited similar light transmittance to that observed before the heat treatment at both wavelengths of 400 nm and 350 nm, and the external appearance following the heat treatment exhibited almost no discoloration compared to the color before the heat treatment, confirming that the cured products had excellent heat resistance.

In contrast, following the heat treatment at 200°C, the cured products of the silicone resin compositions of the comparative examples exhibited completely different light transmittance to that observed before the heat treatment at both wavelengths of 400 nm and 350 nm, and the external appearance following the heat treatment was also very different, with the cured products being transparent before the heat treatment but suffering from yellow discoloration after the heat treatment, thus confirming inferior heat resistance.

The above evaluations of light resistance revealed that following the light irradiation treatment, the cured products of the silicone resins obtained in each of the examples exhibited similar light transmittance to that observed before the light irradiation treatment at both wavelengths of 400 nm and 350 nm, and the external appearance following the light irradiation treatment exhibited almost no discoloration compared to the color before the light irradiation treatment, confirming that the cured products had excellent light resistance.

In contrast, following the light irradiation treatment, the cured products of the silicone resin compositions of the comparative examples exhibited completely different light transmittance to that observed before the light irradiation treatment at both wavelengths of 400 nm and 350 nm, and the external appearance following the heat treatment was also very different, with the cured products being transparent before the light irradiation treatment but suffering from yellow discoloration after the light irradiation treatment, thus confirming inferior light resistance.

In this manner, the cured products of the silicone resins obtained in each of the examples described above exhibit satisfactory suppression of degradation caused by oxidation reactions.

<Production of silicone resins and cured products thereof in which all of the fluoroalkyl groups bonded to silicon atoms are partially fluorinated alkyl groups>

[Example 12]

A flask placed in an oil bath was charged with trimethoxy(3,3,3-trifluoropropyl)silane (2.5 g, manufactured by Tokyo Chemical Industry Co., Ltd.), trimethoxy(1H,1H,2H,2H-nonafluorohexyl)silane (2.5 g, manufactured by Tokyo Chemical Industry Co., Ltd.) and a mixture (0.25 g) of 15% phosphoric acid and an alkoxysilane represented by general formula (D) shown below (wherein n represents a positive number of 3 to 7), and the resulting mixture was stirred at room temperature for 5 minutes to obtain a condensation product solution.

Subsequently, this solution (0.46 g) was placed in an aluminum cup, the cup was placed in an oven, and the temperature was raised from room temperature to 40°C at a rate of 5°C/minute, held at 40°C for 10 minutes, raised to 100°C at 3°C/minute, held at 100°C for 5 hours, raised to 150°C at 3°C/minute, and then held at 150°C for 5 hours, thus obtaining a cured product of the condensation product (polymer). The values of X and Y calculated from the weights added of the components were X=63 and Y=37.

[Chemical formula 12]

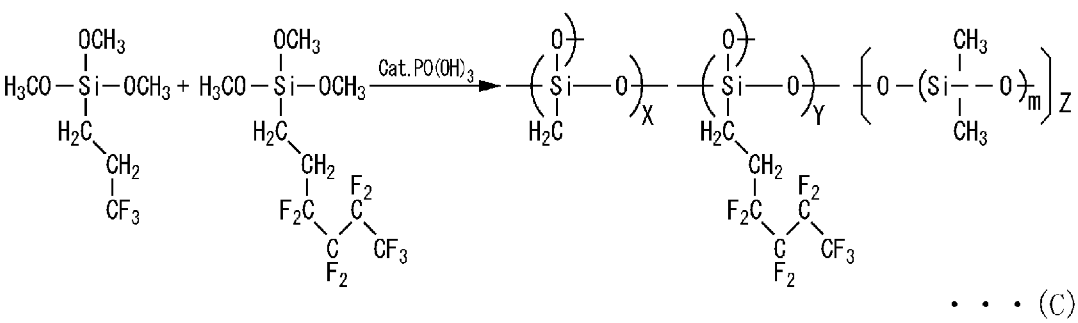


・・・(C)

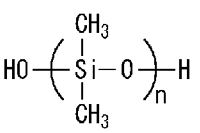

・・・(D)

[Example 13]

A flask placed in an oil bath was charged with trimethoxy(3,3,3-trifluoropropyl)silane (3.8 g, manufactured by Tokyo Chemical Industry Co., Ltd.), trimethoxy(1H,1H,2H,2H-nonafluorohexyl)sllane (1.3 g, manufactured by Tokyo Chemical Industry Co., Ltd.) and a mixture (0.25 g) of 15% phosphoric acid and an alkoxysilane represented by general formula (D) shown below (wherein n represents a positive number of 3 to 7), and the resulting mixture was stirred at room temperature for 5 minutes to obtain a condensation product solution.

Subsequently, this solution (0.46 g) was placed in an aluminum cup, the cup was placed in an oven, and the temperature was raised from room temperature to 40°C at a rate of 5°C/minute, held at 40°C for 10 minutes, raised to 100°C at 3°C/minute, held at 100°C for 5 hours, raised to 150°C at 3°C/minute, and then held at 150°C for 5 hours, thus obtaining a cured product of the condensation product (polymer). The values of X and Y calculated from the weights added of the components were X=84 and Y=16.

[Chemical formula 13]

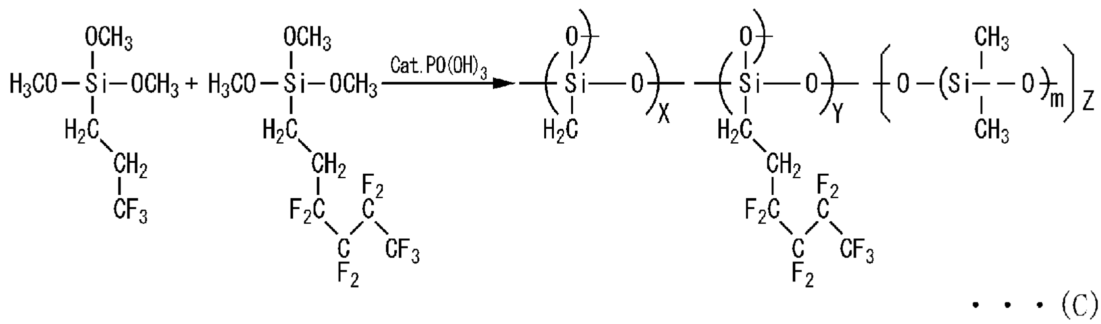


• • • (C)

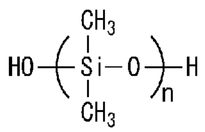

• • • (D)

[Comparative Example 2]

A flask placed in an oil bath was charged with 186 parts by mass of a silicone resin having the repeating structure shown below in Table 1 and 100 parts by mass of isopropyl alcohol, and the temperature was then raised under constant stirring until the liquid temperature reached 85°C to thoroughly dissolve the resin. Subsequently, 18 parts by mass of a silicone resin having the repeating structure shown below in Table 2 and 2 parts by weight of a commercially available silicone resin different from both the silicone resin of Table 1 and the silicone resin of Table 2 were added, and the resulting mixture was stirred for at least one hour to dissolve the silicone resins.

Subsequently, 65 parts by mass of 2-butoxyethyl acetate and 0.05 parts by mass of 3-glycidoxypropyltrimethoxysilane as a silane coupling agent were added to the obtained resin solution, and the resulting solution was then set in an evaporator and held under conditions including a temperature for the resin composition of 70°C and a pressure of 4 kPa, thereby removing the isopropyl alcohol by distillation until the concentration of isopropyl alcohol in the resin composition was reduced to not more than 1% by mass, thus obtaining a silicone resin composition.

[Table 1]

| | | | |
|---|---|---|---|
| Repeating unit | 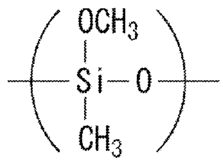 | 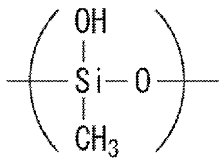 | 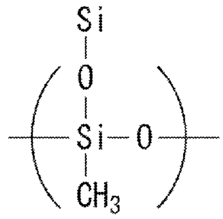 |
| Abundance ratio | 0.08 | 0.15 | 0.77 |

[Table 2]

| | | | |
|---|---|---|---|
| Repeating unit | 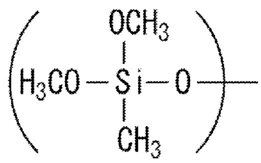 | 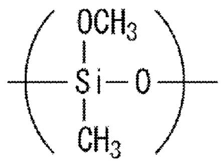 | 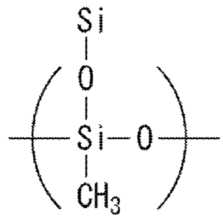 |
| Abundance ratio | 0.39 | 0.49 | 0.12 |

Two parts by mass of a mixture of 15% phosphoric acid and an alkoxysilane represented by general formula (D) shown above (wherein n represents a positive number of 3 to 7) was added to 100 parts by mass of the obtained silicone resin composition, the resulting mixture was stirred at room temperature until a uniform solution was obtained, and this solution (0.46 g) was placed in an aluminum cup, the cup was placed in an oven, and the temperature was raised from room temperature to 40°C at a rate of 5°C/minute, held at 40°C for 10 minutes, raised to 100°C at 3°C/minute, held at 100°C for 5 hours, raised to 150°C at 3°C/minute, and then held at 150°C for 5 hours, thus obtaining a cured product.

(Evaluation of light resistance)

The infrared absorption spectra of the cured products of the above condensation products and silicone resin compositions were measured.

Subsequently, each cured product was heated to 100°C on a hotplate and subjected to a light irradiation treatment by irradiating UV light (230 to 450 nm) onto the cured product for 50 hours using a UV irradiation device SP-9 manufactured by Ushio Inc., and the infrared absorption spectrum of the cured product was then remeasured.

The peak intensity at 1260 to 1270 $cm^{-1}$ attributable to Si-CH, and the peak intensity at 950 to 1180 $cm^{-1}$ attributable to Si-O-Si were then compared for the cured product before and after the light irradiation. The results are shown in Table 3.

[Table 3]

| | Si-CH intensity/Si-O-Si intensity | |
|---|---|---|
| | Before UV irradiation | After UV irradiation |
| Cured product of Example 12 | 1.00 | 1.00 |
| Cured product of Example 13 | 1.00 | 0.97 |
| Cured product of Comparative Example 2 | 1.00 | 0.88 |

Based on the above evaluations of light resistance, compared with the cured product of the silicone resin composition of Comparative Example 2, the cured products of the silicone resins obtained in each of the above examples (Example 12 and Example 13) displayed less conversion from Si-CH bonds to Si-O-Si linkages as a result of the light irradiation treatment, confirming superior light resistance.

In this manner, the cured products of the silicone resins obtained in each of the above examples exhibit satisfactory suppression of degradation caused by oxidation reactions

INDUSTRIAL APPLICABILITY

The present invention can be used in semiconductor light-emitting elements, and particularly for the encapsulating material for UV-LEDs, and is therefore extremely useful industrially.

DESCRIPTION OF THE REFERENCE SIGNS

100: Semiconductor light-emitting device
110: Substrate
120: Semiconductor light-emitting element
130: Encapsulating portion

## Claims

1. A silicone resin which is a condensation product of a silane compound, the condensation product of the silane compound comprising a constitutional unit derived from a fluorine atom-containing silane compound in which a fluoroalkyl group having at least one fluorine atom is bonded to a silicon atom.

2. The silicone resin according to Claim 1, wherein the constitutional unit derived from the fluorine atom-containing silane compound is a constitutional unit derived from a compound represented by general formula (1) shown below, and a proportion of constitutional units derived from the fluorine atom-containing silane compound relative to a total mass of the condensation product of the silane compound is at least 52% by mass:

$$R^1_nSiX^1_{4-n} \text{....} \quad (1)$$

wherein n represents 1 or 2, $R^1$ represents a partially fluorinated alkyl group having 1 to 20 carbon atoms, and $X^1$ represents an alkoxy group, a chlorine atom, a bromine atom or an iodine atom.

3. The silicone resin according to Claim 1, wherein the constitutional unit derived from the fluorine atom-containing silane compound is a constitutional unit derived from a compound represented by general formula (2) shown below, and an average functional number of the silicone resin is not more than 3.0:

$$R^2_mSiX^2_{4-m} \text{....} \quad (2)$$

wherein m represents 1 or 2, $R^2$ represents a perfluoroalkyl group having 1 to 20 carbon atoms, and $X^2$ represents an alkoxy group, a chlorine atom, a bromine atom or an iodine atom.

4. The silicone resin according to any one of Claims 1 to 3, wherein the number of carbon atoms in the fluoroalkyl group of the constitutional unit derived from the fluorine atom-containing silane compound is from 1 to 3.

5. An encapsulating material composition for a UV-LED, the encapsulating material composition comprising the silicone resin according to any one of Claims 1 to 4, and one or more other components.

6. A cured product of the silicone resin according to any one of Claims 1 to 4.

7. An encapsulating material for a UV-LED, the encapsulating material comprising a cured product of the silicone resin according to any one of Claims 1 to 4.

FIG. 1

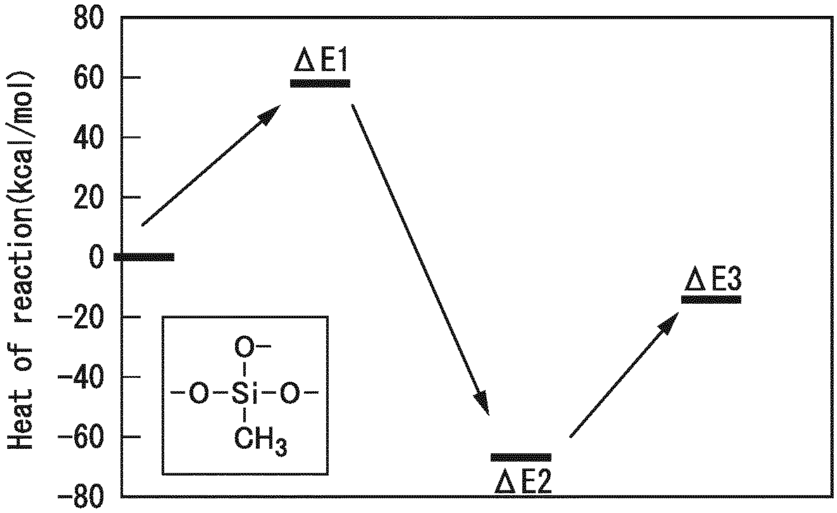
Heat of reaction(kcal/mol)
80
60
40
20
0
-20
-40
-60
-80
ΔE1
ΔE2
ΔE3

FIG. 2

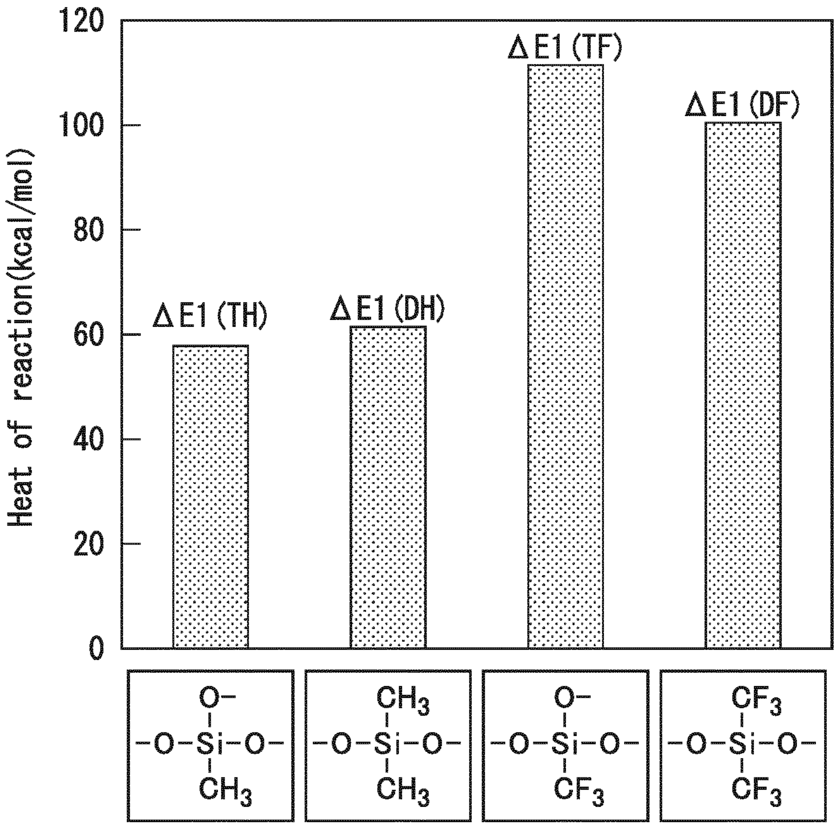
Heat of reaction(kcal/mol)
120
100
80
60
40
20
0
ΔE1 (TH)
ΔE1 (DH)
ΔE1 (TF)
ΔE1 (DF)

FIG. 3

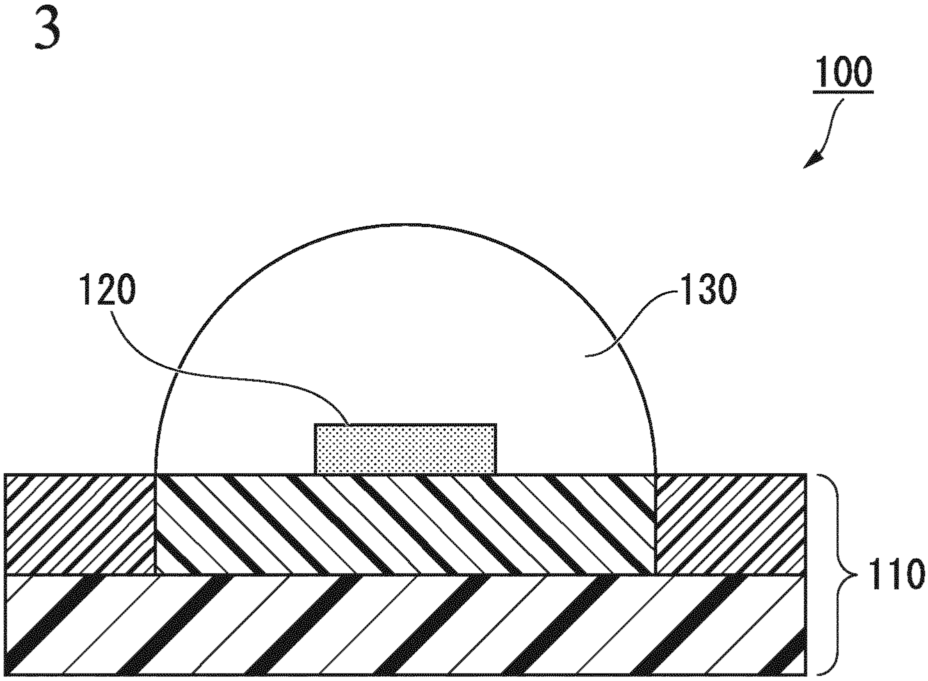

**INTERNATIONAL SEARCH REPORT**

International application No.
PCT/JP2015/077492

A. CLASSIFICATION OF SUBJECT MATTER
*C08G77/24*(2006.01)i, *H01L33/56*(2010.01)i

According to International Patent Classification (IPC) or to both national classification and IPC

B. FIELDS SEARCHED

Minimum documentation searched (classification system followed by classification symbols)
C08G77/24, H01L33/56

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X | JP 2014-118520 A (Shin-Etsu Chemical Co., Ltd.), 30 June 2014 (30.06.2014), claims; paragraph [0014]; preparation examples 2, 3; examples & US 2014/0171599 A1 claims; paragraphs [0023], [0088], [0089]; examples & CN 103865268 A & KR 10-2014-0079296 A & TW 201437272 A | 1-7 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 20 October 2015 (20.10.15) | 22 December 2015 (22.12.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

**INTERNATIONAL SEARCH REPORT**

International application No.
PCT/JP2015/077492

C (Continuation). DOCUMENTS CONSIDERED TO BE RELEVANT

| Category* | Citation of document, with indication, where appropriate, of the relevant passages | Relevant to claim No. |
|---|---|---|
| X | JP 2013-010881 A (Shin-Etsu Chemical Co., Ltd.), 17 January 2013 (17.01.2013), claims; paragraph [0015]; preparation examples 2, 3; examples & CN 102850803 A & KR 10-2013-0009621 A & TW 201319168 A | 1-7 |
| X | WO 2009/101753 A1 (Lintec Corp.), 20 August 2009 (20.08.2009), claims; example 4 & JP 5400624 B & US 2011/0034659 A1 claims; example 4 & KR 10-2010-0126685 A & CN 102007165 A & TW 200946566 A & CN 103360601 A | 1,2,4-7 |
| X | JP 11-292971 A (Mitsubishi Electric Corp.), 26 October 1999 (26.10.1999), claims; examples (Family: none) | 1-4,6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2014205230 A
- JP 2005036155 A
- JP H0953022 A

### Non-patent literature cited in the description


- *Journal of Organometallic Chemistry,* 1986, vol. 316, 41
- *Angew. Chem. Int. Ed.,* vol. 53, 5206